# EUROPEAN PATENT APPLICATION

(11) **EP 4 564 427 A2**
(43) Date of publication of application: **04.06.2025**
(21) Application number: 24215840.0
(22) Date of filing: 27.11.2024
(51) Int. Cl.: H01L 25/07, H01H 71/02, H01L 23/373, H01L 23/498

(54) **POWER MODULE AND PHOTOVOLTAIC OPTIMIZER**

(30) Priority: 28.11.2023 CN 202311614767
(71) Applicant: Huawei Digital Power Technologies Co., Ltd., Shenzhen, Guangdong 518043 (CN)
(72) Inventor: OUYANG, Mize, Shenzhen, 518043 (CN); KONG, Jingyang, Shenzhen, 518043 (CN)
(74) Representative: Gill Jennings & Every LLP

(57) **Abstract**

This application provides a power module and a photovoltaic optimizer. The power module includes a first substrate, a second substrate, a first power device, a second power device, a potential moving point lead, and a ground lead. The second substrate, the first power device, the second power device, the potential moving point lead, and the ground lead are all disposed on a side of the first substrate. The first substrate includes a first insulation layer, a first conductive layer, and a second conductive layer, and the first conductive layer and the second conductive layer are stacked on two opposite sides of the first insulation layer. The second substrate includes a second insulation layer and a first power distribution layer, the second insulation layer is disposed on a side that is of the first conductive layer and that is away from the first insulation layer, and the first power distribution layer is stacked on a side that is of the second insulation layer and that is away from the first conductive layer. The first power device and the second power device are electrically connected to the potential moving point lead, the first power device and the second power device are alternately turned on and turned off, the potential moving point lead and the first power distribution layer share potential, and the ground lead and the first conductive layer share potential. The potential moving point lead implements electromagnetic shielding via the first conductive layer.

## Description

### TECHNICAL FIELD

This application relates to the field of electronic technologies, and in particular, to a power module and a photovoltaic optimizer.

### BACKGROUND

As a size of a photovoltaic optimizer becomes smaller, electromagnetic interference between a power module and another component in the photovoltaic optimizer becomes increasingly severe. As a result, performance of the power module deteriorates, and even the power module is damaged. In the conventional technology, a shielding frame is disposed outside a power module, to implement electromagnetic shielding on the power module. This greatly improves performance of the power module. However, in this manner, mounting space needs to be reserved for the shielding frame, which is not conducive to a miniaturization design of the power module.

### SUMMARY

This application provides a power module and a photovoltaic optimizer. In the power module provided in this application, electromagnetic shielding on the power module can be implemented while a shielding frame is not disposed. This facilitates a miniaturization design of the power module. In addition, the power module is easy to manufacture and has low processing costs, a low processing failure risk, and high reliability.

According to a first aspect, an embodiment of this application provides a power module. The power module includes a first substrate, a second substrate, a first power device, a second power device, a potential moving point lead, and a ground lead. The second substrate, the first power device, the second power device, the potential moving point lead, and the ground lead are all disposed on a side of the first substrate. The first substrate includes a first insulation layer, a first conductive layer, and a second conductive layer, and the first conductive layer and the second conductive layer are stacked on two opposite sides of the first insulation layer. The second substrate includes a second insulation layer and a first power distribution layer, the second insulation layer is disposed on a side that is of the first conductive layer and that is away from the first insulation layer, and the first power distribution layer is stacked on a side that is of the second insulation layer and that is away from the first conductive layer. Both the first power device and the second power device are electrically connected to the potential moving point lead, the first power device and the second power device are alternately turned on and turned off, the potential moving point lead and the first power distribution layer share potential, and the ground lead and the first conductive layer share potential.

The power module provided in this embodiment of this application is configured to: receive a direct current, and perform maximum power point tracking on the direct current, to output a maximum-power direct current. The first power device and the second power device are alternately turned on and turned off, so that the power module can perform maximum power point tracking on the direct current, and output the maximum-power direct current from the potential moving point lead. Because the first power device and the second power device are alternately turned on and turned off, an electrical frequency of the potential moving point lead continuously changes, and the potential moving point lead generates strong electromagnetic interference.

Because the first conductive layer and the second conductive layer are stacked on the two opposite sides of the first insulation layer, the second insulation layer is disposed on the side that is of the first conductive layer and that is away from the first insulation layer, and the first power distribution layer is stacked on the side that is of the second insulation layer and that is away from the first conductive layer, the first conductive layer is located between the first power distribution layer and the second conductive layer. In addition, because the ground lead and the first conductive layer share potential, the first conductive layer is grounded via the ground lead, and the first power distribution layer is electromagnetically shielded from the second conductive layer via the first conductive layer. Because the potential moving point lead and the first power distribution layer share potential, the potential moving point lead is electromagnetically shielded from the second conductive layer via the first conductive layer, and electromagnetic interference caused by the potential moving point lead is shielded by the first conductive layer. In this way, electromagnetic shielding on the potential moving point lead is implemented, and electromagnetic shielding on the power module is further implemented.

Compared with an existing solution in which a shielding frame is disposed outside the power module to implement electromagnetic shielding on the power module, in this application, the shielding frame may not be disposed, and mounting space may not be reserved for the shielding frame. This facilitates a miniaturization design of the power module. In addition, the power module is easy to manufacture and has a simple structure, low processing costs, a low processing failure risk, and high reliability.

In a possible implementation, a projection of the first power distribution layer in a thickness direction of the first substrate is completely located in a projection of the first conductive layer in the thickness direction of the first substrate.

A design in which the projection of the first power distribution layer in the thickness direction of the first substrate is completely located in the projection of the first conductive layer in the thickness direction of the first substrate helps improve an effect of electromagnetic shielding of the first conductive layer on the first power distribution layer, further helps improve an effect of implementing electromagnetic shielding between the second conductive layer and the first power distribution layer via the first conductive layer, and helps improve an effect of electromagnetic shielding on the power module.

In a possible implementation, the second substrate includes a power distribution connection layer, and the power distribution connection layer is stacked between the first conductive layer and the second insulation layer, and is electrically connected to the first conductive layer.

Because the power distribution connection layer is stacked between the first conductive layer and the second insulation layer, the power distribution connection layer is located between the first power distribution layer and the second conductive layer. In addition, because the power distribution connection layer is electrically connected to the first conductive layer, and the power distribution connection layer is grounded via the first conductive layer, the power distribution connection layer may implement an electromagnetic shielding function. The first power distribution layer can be electromagnetically shielded from the second conductive layer via both the power distribution connection layer and the first conductive layer, which helps improve an electromagnetic shielding effect.

In a possible implementation, the potential moving point lead is stacked on a side that is of the first power distribution layer and that is away from the second insulation layer, and is electrically connected to the first power distribution layer. Alternatively, the first substrate includes a connection conductive layer, the connection conductive layer is stacked on a side that is of the first insulation layer and that faces the first conductive layer, the connection conductive layer is electrically connected to the first power distribution layer, and the potential moving point lead is stacked on a side that is of the connection conductive layer and that is away from the first insulation layer, and is electrically connected to the connection conductive layer.

The potential moving point lead and the first power distribution layer are stacked, so that the potential moving point lead is electrically connected to the first power distribution layer, and a design in which the potential moving point lead and the first power distribution layer share potential is implemented. This design not only has a simple and stable structure, but also has low processing costs, and helps improve structural stability of the power module.

Because the connection conductive layer is electrically connected to the first power distribution layer, and the potential moving point lead is stacked on the connection conductive layer, and is electrically connected to the connection conductive layer, the potential moving point lead is electrically connected to the first power distribution layer via the connection conductive layer, and the potential moving point lead and the first power distribution layer share potential via the connection conductive layer. The potential moving point lead may be disposed on the first substrate, and the potential moving point lead is arranged in various manners.

In a possible implementation, the second substrate includes a second power distribution layer, the second power distribution layer is stacked on a side that is of the second insulation layer and that faces the first power distribution layer, and is electrically connected to the first conductive layer, and the ground lead is stacked on a side that is of the second power distribution layer and that is away from the second insulation layer, and is electrically connected to the second power distribution layer. Alternatively, the ground lead is stacked on the side that is of the first conductive layer and that is away from the first insulation layer, and is electrically connected to the first conductive layer.

Because the second power distribution layer is electrically connected to the first conductive layer, and the ground lead is stacked on the side that is of the second power distribution layer and that is away from the second insulation layer, and is electrically connected to the second power distribution layer, the ground lead is electrically connected to the first conductive layer via the second power distribution layer, the ground lead and the first conductive layer share potential via the second power distribution layer, and the first conductive layer is grounded via the ground lead. The ground lead is disposed on the second substrate, to facilitate arrangement of the ground lead, and help reduce cabling difficulty.

The ground lead and the first conductive layer are stacked, so that the ground lead is electrically connected to the first conductive layer, and a design in which the ground lead and the first conductive layer share potential is implemented. This design not only has a simple and stable structure, but also has low processing costs, and helps improve structural stability of the power module.

In a possible implementation, the second substrate includes a third power distribution layer, the third power distribution layer is stacked on a side that is of the second insulation layer and that faces the first power distribution layer, and is electrically connected to the first power distribution layer, the first power device is stacked on a side that is of the third power distribution layer and that is away from the second insulation layer, and is electrically connected to the third power distribution layer, and the second power device is stacked on the side that is of the first power distribution layer and that is away from the second insulation layer, and is electrically connected to the first power distribution layer.

Because the potential moving point lead is electrically connected to the first power distribution layer, and the third power distribution layer is electrically connected to the first power distribution layer, the potential moving point lead is electrically connected to the third power distribution layer via the first power distribution layer. In addition, because the first power device is stacked on the side that is of the third power distribution layer and that is away from the second insulation layer, and is electrically connected to the third power distribution layer, the first power device is electrically connected to the potential moving point lead via the third power distribution layer and the first power distribution layer. A design in which the first power device and the third power distribution layer are stacked helps increase a connection area between the first power device and the third power distribution layer, helps enhance strength of connection between the first power device and the third power distribution layer, and helps improve structural stability of the power module.

Because the potential moving point lead is electrically connected to the first power distribution layer, and the second power device is stacked on the side that is of the first power distribution layer and that is away from the second insulation layer, and is electrically connected to the first power distribution layer, the second power device is electrically connected to the potential moving point lead via the first power distribution layer. A design in which the second power device and the first power distribution layer are stacked helps increase a connection area between the second power device and the first power distribution layer, helps enhance strength of connection between the second power device and the first power distribution layer, and helps improve structural stability of the power module.

In a possible implementation, the power module includes a protection device and a fitting lead, the second substrate includes a fourth power distribution layer, the fourth power distribution layer is stacked on a side that is of the second insulation layer and that faces the first power distribution layer, and both the protection device and the fitting lead are stacked on a side that is of the fourth power distribution layer and that is away from the second insulation layer, and are electrically connected to the fourth power distribution layer. Alternatively, the first substrate includes a third conductive layer, the third conductive layer is stacked on a side that is of the first insulation layer and that faces the first conductive layer, and both the protection device and the fitting lead are stacked on a side that is of the third conductive layer and that is away from the first insulation layer, and are electrically connected to the third conductive layer.

The fitting lead is electrically connected to a load device, and the protection device is electrically connected to the load device via the fitting lead. When both the first power device and the second power device are faulty, the protection device protects the load device, to avoid damage or burning of the load device, which helps improve use security of the power module.

In a possible implementation, the ground lead includes a ground pin, the potential moving point lead includes a potential moving point pin, and both the ground pin and the potential moving point pin are spaced from the first substrate and the second substrate. The power module includes a molding part, the molding part covers the first substrate, the second substrate, the first power device, the second power device, the ground lead, and the potential moving point lead, and the second conductive layer, the ground pin, and the potential moving point pin are all exposed outside the molding part.

The molding part covers the first substrate, the second substrate, the first power device, the second power device, the ground lead, and the potential moving point lead, so that the first substrate, the second substrate, the first power device, the second power device, the ground lead, and the potential moving point lead are packaged. A design of the molding part helps improve structural stability of the power module.

In a possible implementation, the molding part is provided with a first groove, the first groove is located on a side that is of the ground lead and that faces the second conductive layer, a projection of the first groove in the thickness direction of the first substrate overlaps a projection of the ground lead in the thickness direction of the first substrate, and the first groove is configured to increase a creepage distance between the second conductive layer and the ground lead.

A design of the first groove greatly increases the creepage distance between the second conductive layer and the ground lead without increasing a size of the power module. This helps reduce a probability of an electric leakage risk in the power module, and helps improve use security of the power module.

In a possible implementation, the molding part is provided with a first fitting groove, the first fitting groove is located on a side that is of the ground lead and that is away from the second conductive layer, and a projection of the first fitting groove in the thickness direction of the first substrate overlaps the projection of the first groove in the thickness direction of the first substrate.

The second conductive layer may be stacked on a heat dissipation substrate. A design of the first fitting groove can ensure that stress generated when the second conductive layer and the heat dissipation substrate are stacked is not concentrated on a part, provided with the first fitting groove, of the molding part, to avoid a crack generated on the part, provided with the first fitting groove, of the molding part. This helps improve reliability of the molding part, and helps improve structural stability of the power module.

In a possible implementation, the molding part is provided with a second groove, the second groove is located on a side that is of the potential moving point lead and that faces the second conductive layer, a projection of the second groove in the thickness direction of the first substrate overlaps a projection of the potential moving point lead in the thickness direction of the first substrate, and the second groove is configured to increase a creepage distance between the second conductive layer and the potential moving point lead.

A design of the second groove greatly increases the creepage distance between the second conductive layer and the potential moving point lead without increasing a size of the power module. This helps reduce a probability of an electric leakage risk in the power module, and helps improve use security of the power module.

In a possible implementation, the molding part is provided with a second fitting groove, the second fitting groove is located on a side that is of the potential moving point lead and that is away from the second conductive layer, and a projection of the second fitting groove in the thickness direction of the first substrate overlaps the projection of the second groove in the thickness direction of the first substrate.

A design of the second fitting groove can ensure that stress generated when the second conductive layer and the heat dissipation substrate are stacked is not concentrated on a part, provided with the second fitting groove, of the molding part, to avoid a crack generated on the part, provided with the second fitting groove, of the molding part. This helps improve reliability of the molding part, and helps improve structural stability of the power module.

In a possible implementation, the ground pin and the first substrate are stacked.

Alternatively, the ground pin is disposed perpendicular to the first substrate, and extends in a direction away from the first substrate.

The ground pin has various structures, and a design requirement of the ground pin is low. This helps reduce design costs, and helps reduce manufacturing costs of the power module.

In a possible implementation, the potential moving point pin and the first substrate are stacked.

Alternatively, the potential moving point pin is disposed perpendicular to the first substrate, and extends in a direction away from the first substrate.

The potential moving point pin has various structures, and a design requirement of the potential moving point pin is low. This helps reduce design costs, and helps reduce manufacturing costs of the power module.

In a possible implementation, the power module includes a heat dissipation substrate, and the heat dissipation substrate is stacked on a side that is of the second conductive layer and that is away from the first insulation layer.

The first power device and the second power device emit a large amount of heat during operation. The large amount of heat emitted by the first power device and the second power device during operation may be transferred to the heat dissipation substrate from the second conductive layer through the first substrate, and then dissipated to an external environment through the heat dissipation substrate, to quickly dissipate heat for the first power device and the second power device. A design of the heat dissipation substrate helps improve efficiency of dissipating heat for the first power device and the second power device, and helps improve efficiency of dissipating heat for the power module.

According to a second aspect, an embodiment of this application further provides a photovoltaic optimizer. The photovoltaic optimizer includes a control module and the power module according to any one of the possible implementations in the first aspect, and the control module is configured to control the first power device and the second power device to be alternately turned on and turned off.

### BRIEF DESCRIPTION OF DRAWINGS

To describe the technical solutions in embodiments of this application or in the background more clearly, the following describes accompanying drawings for describing embodiments of this application or the background.
FIG. 1 is a block diagram of a structure in which a photovoltaic optimizer cooperates with a photovoltaic module and a load device according to an embodiment of this application;
FIG. 2 is a diagram of a structure of a power module of the photovoltaic optimizer shown in FIG. 1;
FIG. 3 is a diagram of a structure of the power module shown in FIG. 2 without a molding part;
FIG. 4 is a diagram of a structure of the power module shown in FIG. 2 that is cut along an A-A line;
FIG. 5 is a diagram of a structure of a substrate of the power module shown in FIG. 2;
FIG. 6 is a diagram of a structure of the substrate shown in FIG. 5 that is cut along a B-B line;
FIG. 7 is a diagram of a structure of the power module shown in FIG. 2 that is cut along a C-C line;
FIG. 8 is a diagram of a structure of the power module shown in FIG. 2, without a heat dissipation substrate, that is cut along an A-A line;
FIG. 9 is a diagram of a structure of the power module shown in FIG. 2 according to another embodiment;
FIG. 10 is a diagram of a structure of the power module shown in FIG. 9 that is cut along a D-D line;
FIG. 11 is a diagram of a structure of the power module shown in FIG. 10 without a molding part 90 at another angle;
FIG. 12 is a diagram of a structure of the power module shown in FIG. 9 that is cut along a D-D line according to another embodiment;
FIG. 13 is a diagram of a structure of the power module shown in FIG. 12 without a molding part at another angle;
FIG. 14 is a diagram of a structure of the power module shown in FIG. 9 that is cut along a D-D line according to another embodiment; and
FIG. 15 is a diagram of a structure of the power module shown in FIG. 9 that is cut along a D-D line according to another embodiment.

### DESCRIPTION OF EMBODIMENTS

Embodiments of this application provide a power module and a photovoltaic optimizer. The power module is used in the photovoltaic optimizer. In the power module provided in this application, electromagnetic shielding on the power module can be implemented while a shielding frame is not disposed. This facilitates a miniaturization design of the power module. In addition, the power module is easy to manufacture and has low processing costs, a low processing failure risk, and high reliability. In this application, a "connection" between a feature A and a feature B means that the feature A and the feature B are fastened and electrically connected.

The following describes embodiments of this application with reference to accompanying drawings in embodiments of this application.

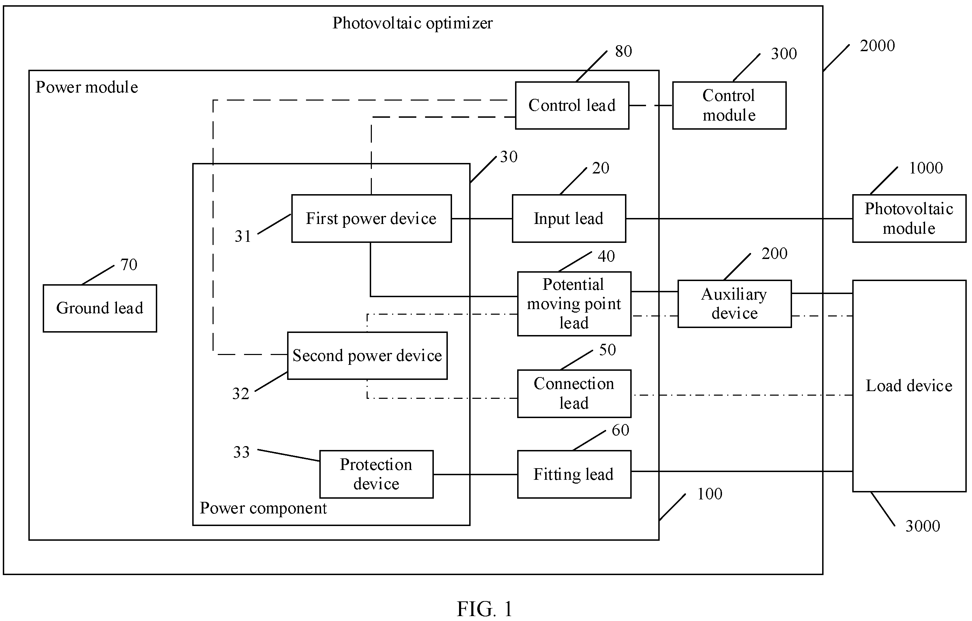

FIG. 1 is a block diagram of a structure in which a photovoltaic optimizer 2000 cooperates with a photovoltaic module 1000 and a load device 3000 according to an embodiment of this application. The photovoltaic module 1000 is configured to: convert light energy into electric energy and output a direct current. The photovoltaic optimizer 2000 is configured to: perform maximum power point tracking on the direct current output by the photovoltaic module 1000, and output a maximum-power direct current to the load device 3000, to supply the maximum-power direct current to the load device 3000. The photovoltaic module 1000 may be an electronic device that may convert light energy into electric energy and that includes but is not limited to a solar panel. The load device 3000 may be an electronic device that uses a direct current and that includes but is not limited to a battery or a fan.

The photovoltaic optimizer 2000 includes a power module 100, an auxiliary device 200, and a control module 300. The power module 100 is electrically connected to the photovoltaic module 1000. Both the auxiliary device 200 and the control module 300 are electrically connected to the power module 100. The auxiliary device 200 is electrically connected to the load device 3000. The power module 100 receives the direct current output by the photovoltaic module 1000. The power module 100 cooperates with the auxiliary device 200 to perform maximum power point tracking on the direct current output by the photovoltaic module 1000 and output the maximum-power direct current to the load device 3000, to supply the maximum-power direct current to the load device 3000. In other words, the power module 100 is configured to: perform maximum power point tracking on the direct current, and output the maximum-power direct current to the load device 3000. The control module 300 is configured to control the power module 100 to operate, to ensure that the power module 100 cooperates with the auxiliary device 200 to output the maximum-power direct current to the load device 3000. For example, the auxiliary device 200 is an inductor.

In some embodiments, the power module 100 includes an input lead 20, a power component 30, a potential moving point lead 40, a connection lead 50, a fitting lead 60, and a ground lead 70. The power component 30 includes a first power device 31, a second power device 32, and a protection device 33. In other words, the power module 100 includes the first power device 31, the second power device 32, and the protection device 33. For example, the first power device 31 may be a switch device including but not limited to a transistor or a triode. The second power device 32 may be a switch device including but not limited to a transistor or a triode. The protection device 33 may be a switch device including but not limited to a circuit breaker and a fuse.

The input lead 20 is electrically connected to the photovoltaic module 1000. The first power device 31 is electrically connected to the input lead 20. The potential moving point lead 40 is electrically connected to the first power device 31, and is electrically connected to the auxiliary device 200. The second power device 32 is electrically connected to the potential moving point lead 40, and is electrically connected to the connection lead 50. In other words, both the first power device 31 and the second power device 32 are electrically connected to the potential moving point lead 40. The connection lead 50 is electrically connected to the load device 3000. The protection device 33 is electrically connected to the fitting lead 60. The fitting lead 60 is electrically connected to the load device 3000. A control lead 80 is electrically connected to the control module 300, and is electrically connected to the first power device 31 and the second power device 32. The ground lead 70 is configured for grounding.

It may be understood that the photovoltaic module 1000, the input lead 20, the first power device 31, the potential moving point lead 40, the auxiliary device 200, and the load device 3000 form a first path. The auxiliary device 200, the load device 3000, the connection lead 50, the second power device 32, and the potential moving point lead 40 form a second path. The first power device 31 and the second power device 32 are alternately turned on and turned off, so that the first path and the second path are alternately turned on and turned off. In this way, the power module 100 performs maximum power point tracking on the direct current output by the photovoltaic module 1000, and outputs the maximum-power direct current to the load device 3000, to supply the maximum-power direct current to the load device 3000.

When the first power device 31 is turned on and the second power device 32 is turned off, the direct current output by the photovoltaic module 1000 is transmitted to the first power device 31 from the input lead 20. The first power device 31 performs voltage conversion on the direct current. A direct current converted by the first power device 31 is transmitted to the load device 3000 from the potential moving point lead 40 through the auxiliary device 200, to be supplied to the load device 3000. The auxiliary device 200 is charged for energy storage. When the first power device 31 is turned off and the second power device 32 is turned on, the auxiliary device 200 is discharged and outputs a direct current. Power of the direct current output by the auxiliary device 200 is equal to power of the direct current converted by the first power device 31. The direct current output by the auxiliary device 200 flows back to the auxiliary device 200 through the load device 3000, the connection lead 50, and the second power device 32. The direct current output by the auxiliary device 200 supplies energy to the load device 3000. In a process in which the first power device 31 and the second power device 32 are alternately turned on and turned off, the load device 3000 operates normally.

In a process in which the first power device 31 and the second power device 32 are alternately turned on and turned off, when the first power device 31 is turned off and the second power device 32 is turned on, a parameter (for example, a duty cycle) of the first power device 31 may be adjusted, to adjust the power of the direct current converted by the first power device 31, and adjust power of the direct current received by the load device 3000. When the first power device 31 is turned off and the second power device 32 is turned on, the direct current output by the auxiliary device 200 through discharging may be supplied to the load device 3000, so that the direct current received by the load device 3000 is monitored, and the parameter of the first power device 31 is further adjusted. The parameter of the first power device 31 is adjusted for a plurality of times by monitoring the power of the direct current received by the load device 3000, to ensure that the power of the direct current received by the load device 3000 is maximum, so that maximum power point tracking can be performed on the direct current output by the photovoltaic module 1000, to ensure that the power of the direct current converted by the first power device 31 is maximum.

In other words, the first power device 31 and the second power device 32 are alternately turned on and turned off, so that the power module 100 can perform maximum power point tracking on the direct current, and output the maximum-power direct current from the potential moving point lead 40. When the first power device 31 is turned on and the second power device 32 is turned off, the first power device 31 may perform voltage conversion on the direct current output by the photovoltaic module 1000, and output the maximum-power direct current. The maximum-power direct current is transmitted to the load device 3000 from the potential moving point lead 40 through the auxiliary device 200, to be supplied to the load device 3000. The auxiliary device 200 is charged and stores the maximum-power direct current. When the first power device 31 is turned off and the second power device 32 is turned on, the auxiliary device 200 outputs the maximum-power direct current, and the maximum-power direct current flows back to the auxiliary device 200 through the load device 3000, the connection lead 50, the second power device 32, and the potential moving point lead 40. The maximum-power direct current output by the auxiliary device 200 supplies energy to the load device 3000.

The protection device 33 is electrically connected to the load device 3000 via the fitting lead 60. The protection device 33 is configured to protect the load device 3000. When both the first power device 31 and the second power device 32 are faulty, the protection device 33 protects the load device 3000, to avoid damage or burning of the load device 3000, which helps improve use security of the power module 100 and improve use security of the photovoltaic optimizer 2000. The control module 300 is electrically connected to the first power device 31 and the second power device 32 via the control lead 80. The control module 300 is configured to control the first power device 31 and the second power device 32 to be alternately turned on and turned off, to ensure that the power module 100 cooperates with the auxiliary device 200 to output the maximum-power direct current to the load device 3000.

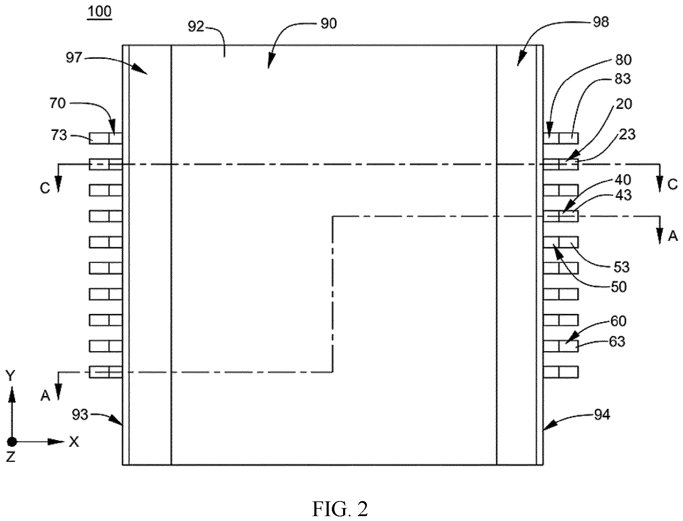

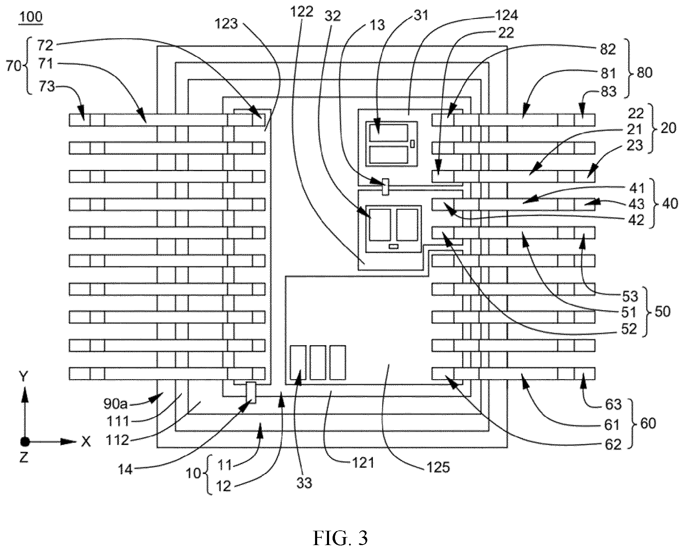

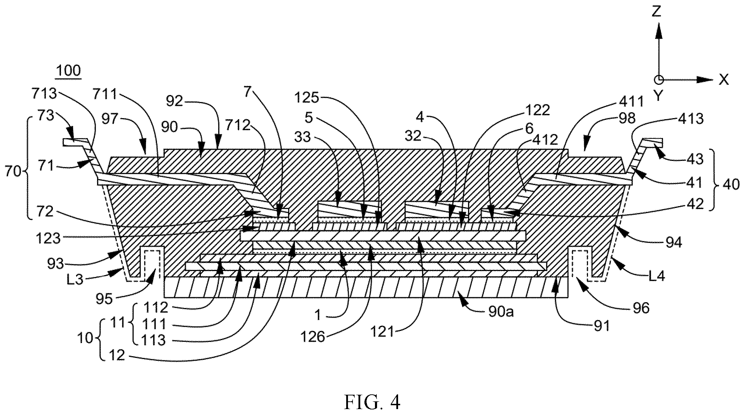

Refer to FIG. 2, FIG. 3, and FIG. 4. FIG. 2 is a diagram of a structure of the power module 100 of the photovoltaic optimizer 2000 shown in FIG. 1. FIG. 3 is a diagram of a structure of the power module 100 shown in FIG. 2 without a molding part 90. FIG. 4 is a diagram of a structure of the power module 100 shown in FIG. 2 that is cut along an A-A line.

As shown in FIG. 2, FIG. 3, and FIG. 4, in some embodiments, the power module 100 further includes a substrate 10, the molding part 90, and a heat dissipation substrate 90a. To be specific, the power module 100 includes the substrate 10, the input lead 20, the first power device 31, the second power device 32, the protection device 33, the potential moving point lead 40, the connection lead 50, the fitting lead 60, the ground lead 70, and the control lead 80, the molding part 90, and the heat dissipation substrate 90a. The input lead 20, the first power device 31, the second power device 32, the protection device 33, the potential moving point lead 40, the connection lead 50, the fitting lead 60, the ground lead 70, and the control lead 80 are all disposed on one side of the substrate 10. The molding part 90 covers a part of the substrate 10, a part of the input lead 20, the first power device 31, the second power device 32, the protection device 33, a part of the potential moving point lead 40, a part of the connection lead 50, a part of the fitting lead 60, a part of the ground lead 70, and a part of the control lead 80. The heat dissipation substrate 90a is mounted on the other side of the substrate 10, and is located outside the molding part 90.

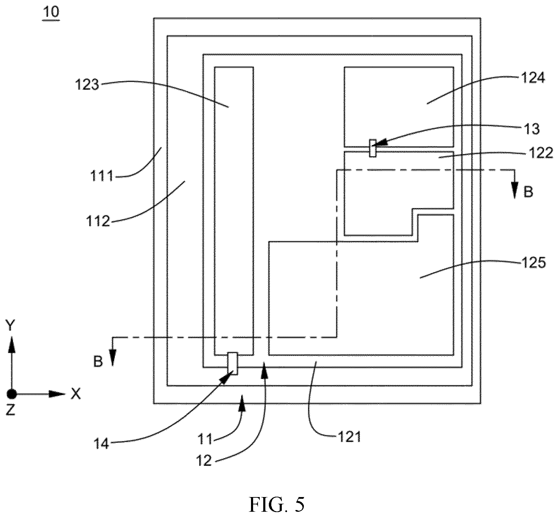

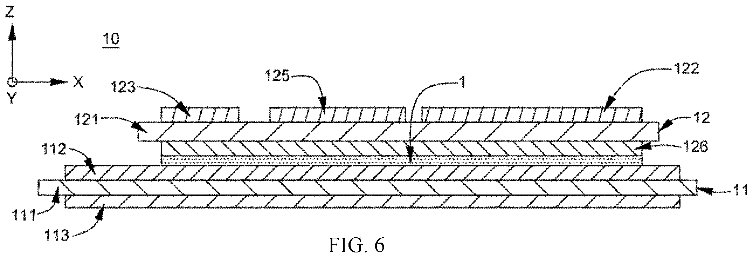

Refer to FIG. 5 and FIG. 6. FIG. 5 is a diagram of a structure of the substrate 10 of the power module 100 shown in FIG. 2. FIG. 6 is a diagram of a structure of the substrate 10 shown in FIG. 5 that is cut along a B-B line.

In some embodiments, the substrate 10 includes a first substrate 11 and a second substrate 12. The second substrate 12 is disposed on a side of the first substrate 11. For example, the first substrate 11 is approximately a rectangular plate. In some other embodiments, the first substrate 11 may alternatively be a circular plate, a triangular plate, or various special-shaped plates. For ease of description, a width direction of the first substrate 11 is defined as a first direction (that is, an X-axis direction shown in the figure), a length direction of the first substrate 11 is defined as a second direction (that is, a Y-axis direction shown in the figure), and a thickness direction of the first substrate 11 is defined as a third direction (that is, a Z-axis direction shown in the figure).

For example, the first substrate 11 may be a ceramic substrate or an aluminum substrate including but not limited to a DBC (DirectBond Copper, direct bond copper substrate) and an AMB (Active Metal Brazing Substrate, active metal brazing substrate). The first substrate 11 includes a first insulation layer 111, a first conductive layer 112, and a second conductive layer 113. For example, the first insulation layer 111 may be made of an insulation material including but not limited to ceramic and epoxy resin. The first conductive layer 112 and the second conductive layer 113 are made of a conductive material including but not limited to copper and aluminum. In the Z-axis direction, the first conductive layer 112 and the second conductive layer 113 are stacked on two opposite sides of the first insulation layer 111. In the Z-axis direction, a projection of the first conductive layer 112 on the first insulation layer 111 is located in a projection of the second conductive layer 113 on the first insulation layer 111.

The second substrate 12 is stacked on a side that is of the first conductive layer 112 of the first substrate 11 and that is away from the first insulation layer 111. For example, the second substrate 12 is approximately a rectangular plate. In some other embodiments, the second substrate 12 may alternatively be a circular plate, a triangular plate, or various special-shaped plates. The second substrate 12 may be a ceramic substrate or an aluminum substrate including but not limited to a DBC (DirectBond Copper, direct bond copper substrate) and an AMB (Active Metal Brazing Substrate, active metal brazing substrate). The second substrate 12 includes a second insulation layer 121, a first power distribution layer 122, a second power distribution layer 123, a third power distribution layer 124, a fourth power distribution layer 125, and a power distribution connection layer 126. For example, the second insulation layer 121 may be made of an insulation material including but not limited to ceramic and epoxy resin. The first power distribution layer 122, the second power distribution layer 123, the third power distribution layer 124, the fourth power distribution layer 125, and the power distribution connection layer 126 are all made of a conductive material including but not limited to copper and aluminum.

In the Z-axis direction, the first power distribution layer 122, the second power distribution layer 123, the third power distribution layer 124, and the fourth power distribution layer 125 are stacked on a side of the second insulation layer 121. In other words, the second power distribution layer 123, the third power distribution layer 124, and the fourth power distribution layer 125 are stacked on a side that is of the second insulation layer 121 and that faces the first power distribution layer 122. In the X-axis direction, the second power distribution layer 123 is located on a side of the first power distribution layer 122, the third power distribution layer 124, and the fourth power distribution layer 125, and is spaced from the first power distribution layer 122, the third power distribution layer 124, and the fourth power distribution layer 125. In the Y-axis direction, the third power distribution layer 124 and the fourth power distribution layer 125 are located on two opposite sides of the first power distribution layer 122, and are both spaced from the first power distribution layer 122. In the Z-axis direction, the power distribution connection layer 126 is stacked on a side that is of the second insulation layer 121 and that is away from the first power distribution layer 122. A projection of the first power distribution layer 122 on the second insulation layer 121, a projection of the second power distribution layer 123 on the second insulation layer 121, a projection of the third power distribution layer 124 on the second insulation layer 121, and a projection of the fourth power distribution layer 125 on the second insulation layer 121 are located in a projection of the power distribution connection layer 126 on the second insulation layer 121.

The power distribution connection layer 126 is stacked on the first conductive layer 112 in a manner including but not limited to soldering or adhesive bonding, and is electrically connected to the first conductive layer 112. For example, a first connecting piece 1 is disposed between the power distribution connection layer 126 and the first conductive layer 112, and the first connecting piece 1 is made of a material including but not limited to tin-lead or a conductive adhesive. The power distribution connection layer 126 is stacked on the first conductive layer 112 via the first connecting piece 1, and is electrically connected to the first conductive layer 112. The second insulation layer 121 is stacked on a side that is of the power distribution connection layer 126 and that is away from the first conductive layer 112. The first power distribution layer 122, the second power distribution layer 123, the third power distribution layer 124, and the fourth power distribution layer 125 are all stacked on a side that is of the second insulation layer 121 and that is away from the first conductive layer 112. A projection of the first power distribution layer 122 in the Z-axis direction (that is, in the thickness direction of the first substrate 11), a projection of the second power distribution layer 123 in the Z-axis direction, a projection of the third power distribution layer 124 in the Z-axis direction, and a projection of the fourth power distribution layer 125 in the Z-axis direction are all located in a projection of the first conductive layer 112 in the Z-axis direction (that is, in the thickness direction of the first substrate 11).

It may be understood that the power distribution connection layer 126 is stacked between the first conductive layer 112 and the second insulation layer 121, and is electrically connected to the first conductive layer 112. The second insulation layer 121 is disposed on the side that is of the first conductive layer 112 and that is away from the first insulation layer 111. In some other embodiments, the power distribution connection layer 126 may alternatively be omitted, and the second insulation layer 121 may alternatively be stacked on the side that is of the first conductive layer 112 and that is away from the first insulation layer 111. In the Z-axis direction, the first conductive layer 112 is located between the second conductive layer 113 and the first power distribution layer 122, and is spaced from the second conductive layer 113 and the first power distribution layer 122.

In some embodiments, a first conductive part 13 is disposed between the first power distribution layer 122 and the third power distribution layer 124. For example, the first conductive part 13 may be a conductive device including but not limited to a cable or a metal part. In a manner including but not limited to soldering or adhesive bonding, one end of the first conductive part 13 is stacked on a side that is of the first power distribution layer 122 and that is away from the second insulation layer 121, and is electrically connected to the first power distribution layer 122; and the other end of the first conductive part 13 is stacked, in a fastening manner, on a side that is of the third power distribution layer 124 and that is away from the second insulation layer 121, and is electrically connected to the third power distribution layer 124. The first power distribution layer 122 is electrically connected to the third power distribution layer 124 via the first conductive part 13. It may be understood that the third power distribution layer 124 is stacked on the side that is of the second insulation layer 121 and that faces the first power distribution layer 122, and is electrically connected to the first power distribution layer 122.

In some embodiments, a second conductive part 14 is disposed between the second power distribution layer 123 and the first conductive layer 112. For example, the second conductive part 14 may be a conductive device including but not limited to a cable or a metal part. In a manner including but not limited to soldering or adhesive bonding, one end of the second conductive part 14 is stacked on a side that is of the second power distribution layer 123 and that is away from the second insulation layer 121, and is electrically connected to the second power distribution layer 123; and the other end of the second conductive part 14 is stacked on the side that is of the first conductive layer 112 and that is away from the first insulation layer 111, and is electrically connected to the first conductive layer 112. The second power distribution layer 123 is electrically connected to the first conductive layer 112 via the second conductive part 14. It may be understood that the second power distribution layer 123 is stacked on the side that is of the second insulation layer 121 and that faces the first power distribution layer 122, and is electrically connected to the first conductive layer 112.

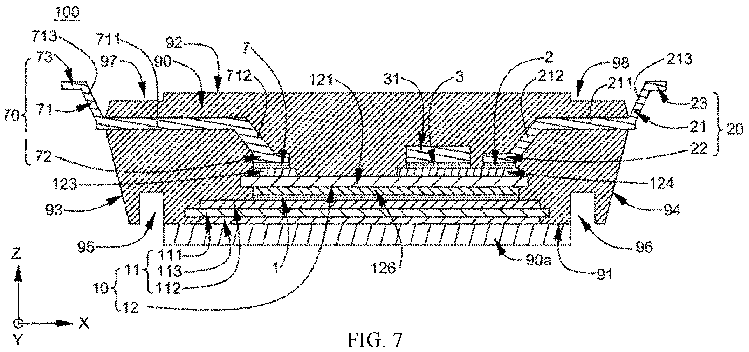

Refer to FIG. 7. With reference to FIG. 1, FIG. 2, FIG. 3, and FIG. 4, FIG. 7 is a diagram of a structure of the power module 100 shown in FIG. 2 that is cut along a C-C line.

As shown in FIG. 3 and FIG. 7, in some embodiments, the input lead 20 is disposed on a side that is of a first substrate 11 and that faces a second substrate 12. Specifically, in a manner including but not limited to soldering or adhesive bonding, the input lead 20 is stacked on a side that is of a third power distribution layer 124 and that is away from a second insulation layer 121, and is electrically connected to the third power distribution layer 124. For example, a second connecting piece 2 is disposed between the input lead 20 and the third power distribution layer 124, and the second connecting piece 2 is made of a material including but not limited to tin-lead or a conductive adhesive. The input lead 20 is stacked, via the second connecting piece 2, on the side that is of the third power distribution layer 124 and that is away from the second insulation layer 121, and is electrically connected to the third power distribution layer 124. In an X-axis direction, the input lead 20 is located on a side that is of the third power distribution layer 124 and that is away from a second power distribution layer 123. For example, there are a plurality of input leads 20. Specifically, there are two input leads 20. In a Y-axis direction, the plurality of input leads 20 are sequentially arranged and spaced from each other. In some other embodiments, there may alternatively be three, four, or more input leads 20.

The input lead 20 and the third power distribution layer 124 are stacked, so that a design in which the input lead 20 is electrically connected to the third power distribution layer 124 is implemented. This design not only has a simple and stable structure, but also has low processing costs, and helps improve structural stability of the power module. In addition, a design in which the input lead 20 and the third power distribution layer 124 are stacked helps increase a connection area between the input lead 20 and the third power distribution layer 124, helps enhance strength of connection between the input lead 20 and the third power distribution layer 124, and helps improve structural stability of the power module 100.

The input lead 20 includes a first main body portion 21, a first fastening portion 22, and an input pin 23. In a Z-axis direction, the first fastening portion 22 and the input pin 23 are fastened to two opposite ends of the first main body portion 21. In the Z-axis direction, the input pin 23 and the first fastening portion 22 are stacked in a staggered manner and spaced from each other. Specifically, the first main body portion 21 includes a first segment 211, a second segment 212, and a third segment 213. The first segment 211 extends in the X-axis direction, and is disposed opposite to and spaced from the first substrate 11. In the Z-axis direction, the second segment 212 and the third segment 213 are located on two opposite sides of the first segment 211. The second segment 212 and the third segment 213 are fastened to two opposite ends of the first segment 211. In addition, both the second segment 212 and the third segment 213 are disposed obliquely relative to the first segment 211. In the Z-axis direction, the first fastening portion 22 is located on a side that is of the second segment 212 and that is away from the first segment 211, and is fastened to the second segment 212. In the Z-axis direction, the input pin 23 is located on a side that is of the third segment 213 and that is away from the first segment 211, and is fastened to the third segment 213.

The second connecting piece 2 is stacked between the first fastening portion 22 and the third power distribution layer 124, and is electrically connected to the first fastening portion 22 and the third power distribution layer 124. The first fastening portion 22 is stacked, via the second connecting piece 2, on the side that is of the third power distribution layer 124 and that is away from the second insulation layer 121, and is electrically connected to the third power distribution layer 124. In the Z-axis direction, the input pin 23 and the third power distribution layer 124 are stacked and spaced from each other. The input pin 23 is electrically connected to the photovoltaic module 1000 (as shown in FIG. 1).

It may be understood that the input pin 23 is spaced from the first substrate 11 and the second substrate 12. In addition, the input pin 23 and the first substrate 11 are stacked. In some other embodiments, the input pin 23 may alternatively be perpendicular to the first substrate 11, and extend in a direction away from the first substrate 11. The input pin 23 has various structures, and a design requirement of the input pin 23 is low. This helps reduce design costs, and helps reduce manufacturing costs of the power module 100. It should be noted that in this application, a feature A is "perpendicular" to a feature B, and a small deviation is allowed.

In some embodiments, the first power device 31 is disposed on the side that is of the first substrate 11 and that faces the second substrate 12. Specifically, in a manner including but not limited to soldering or adhesive bonding, the first power device 31 is stacked on the side that is of the third power distribution layer 124 and that is away from the second insulation layer 121, and is electrically connected to the third power distribution layer 124. For example, a third connecting piece 3 is disposed between the first power device 31 and the third power distribution layer 124, and the third connecting piece 3 is made of a material including but not limited to tin-lead or a conductive adhesive. In the X-axis direction, the first power device 31 is located between the second power distribution layer 123 and the input lead 20.

The first power device 31 is stacked, via the third connecting piece 3, on the side that is of the third power distribution layer 124 and that is away from the second insulation layer 121, and is electrically connected to the third power distribution layer 124. It may be understood that, because both the input lead 20 and the first power device 31 are electrically connected to the third power distribution layer 124, the first power device 31 is electrically connected to the input lead 20 via the third power distribution layer 124. A design in which the first power device 31 and the third power distribution layer 124 are stacked helps increase a connection area between the first power device 31 and the third power distribution layer 124, helps enhance strength of connection between the first power device 31 and the third power distribution layer 124, and helps improve structural stability of the power module 100.

As shown in FIG. 3 and FIG. 4, in some embodiments, the second power device 32 is disposed on the side that is of the first substrate 11 and that faces the second substrate 12. Specifically, in a manner including but not limited to soldering or adhesive bonding, the second power device 32 is stacked on a side that is of a first power distribution layer 122 and that is away from the second insulation layer 121, and is electrically connected to the first power distribution layer 122. For example, a fourth connecting piece 4 is disposed between the second power device 32 and the first power distribution layer 122, and the fourth connecting piece 4 is made of a material including but not limited to tin-lead or a conductive adhesive. The second power device 32 is stacked, via the fourth connecting piece 4, on the side that is of the first power distribution layer 122 and that is away from the second insulation layer 121, and is electrically connected to the first power distribution layer 122. In the Y-axis direction, the second power device 32 is disposed opposite to and spaced from the first power device 31.

A design in which the second power device 32 and the first power distribution layer 122 are stacked helps increase a connection area between the second power device 32 and the first power distribution layer 122, helps enhance strength of connection between the second power device 32 and the first power distribution layer 122, and helps improve structural stability of the power module 100.

In some embodiments, the protection device 33 is disposed on the side that is of the first substrate 11 and that faces the second substrate 12. Specifically, in a manner including but not limited to soldering or adhesive bonding, the protection device 33 is stacked on a side that is of a fourth power distribution layer 125 and that is away from a second insulation layer 121, and is electrically connected to the fourth power distribution layer 125. For example, a fifth connecting piece 5 is disposed between the protection device 33 and the fourth power distribution layer 125, and the fifth connecting piece 5 is made of a material including but not limited to tin-lead or a conductive adhesive. The protection device 33 is stacked, via the fifth connecting piece 5, on the side that is of the fourth power distribution layer 125 and that is away from the second insulation layer 121, and is electrically connected to the fourth power distribution layer 125. In the X-axis direction, the protection device 33 is located between the second power device 32 and a second power distribution layer 123, and is spaced from the second power device 32 and the second power distribution layer 123. In addition, in the Y-axis direction, the protection device 33 is located on a side that is of the second power device 32 and that is away from the first power device 31. A design in which the protection device 33 and the fourth power distribution layer 125 are stacked helps increase a connection area between the protection device 33 and the fourth power distribution layer 125, helps enhance strength of connection between the protection device 33 and the fourth power distribution layer 125, and helps improve structural stability of the power module 100.

In some embodiments, the potential moving point lead 40 is disposed on the side that is of the first substrate 11 and that faces the second substrate 12. Specifically, in a manner including but not limited to soldering or adhesive bonding, the potential moving point lead 40 is stacked on the side that is of the first power distribution layer 122 and that is away from the second insulation layer 121, and is electrically connected to the first power distribution layer 122. For example, a sixth connecting piece 6 is disposed between the potential moving point lead 40 and the first power distribution layer 122, and the sixth connecting piece 6 is made of a material including but not limited to tin-lead or a conductive adhesive. The potential moving point lead 40 is stacked, via the sixth connecting piece 6, on the side that is of the first power distribution layer 122 and that is away from the second insulation layer 121, and is electrically connected to the first power distribution layer 122. In the X-axis direction, the potential moving point lead 40 is located on a side that is of the second power device 32 and that is away from the second power distribution layer 123, and is spaced from the second power device 32. In the Y-axis direction, the potential moving point lead 40 is located on a side of the plurality of input leads 20, and is spaced from the plurality of input leads 20.

The potential moving point lead 40 and the first power distribution layer 122 are stacked, so that the potential moving point lead 40 is electrically connected to the first power distribution layer 122, and a design in which the potential moving point lead 40 and the first power distribution layer 122 share potential is implemented. This design not only has a simple and stable structure, but also has low processing costs, and helps improve structural stability of the power module 100. In addition, a design in which the potential moving point lead 40 and the first power distribution layer 122 are stacked helps increase a connection area between the potential moving point lead 40 and the first power distribution layer 122, helps enhance strength of connection between the potential moving point lead 40 and the first power distribution layer 122, and helps improve structural stability of the power module 100.

The potential moving point lead 40 includes a second main body portion 41, a second fastening portion 42, and a potential moving point pin 43. In the Z-axis direction, the potential moving point pin 43 and the second fastening portion 42 are fastened to two opposite ends of the second main body portion 41. In the Z-axis direction, the potential moving point pin 43 and the second fastening portion 42 are stacked in a staggered manner and spaced from each other. Specifically, the second main body portion 41 includes a fourth segment 411, a fifth segment 412, and a sixth segment 413. The fourth segment 411 extends in the X-axis direction, and is disposed opposite to and spaced from the first substrate 11. In the Z-axis direction, the fifth segment 412 and the sixth segment 413 are located on two opposite sides of the fourth segment 411. The fifth segment 412 and the sixth segment 413 are fastened to two opposite ends of the fourth segment 411. In addition, both the fifth segment 412 and the sixth segment 413 are disposed obliquely relative to the fourth segment 411. In the Z-axis direction, the second fastening portion 42 is located on a side that is of the fifth segment 412 and that is away from the fourth segment 411, and is fastened to the fifth segment 412. In the Z-axis direction, the potential moving point pin 43 is located on a side that is of the sixth segment 413 and that is away from the fourth segment 411, and is fastened to the sixth segment 413.

The sixth connecting piece 6 is stacked between the second fastening portion 42 and the first power distribution layer 122, and is electrically connected to the second fastening portion 42 and the first power distribution layer 122. The second fastening portion 42 is stacked, via the sixth connecting piece 6, on the side that is of the first power distribution layer 122 and that is away from the second insulation layer 121, and is electrically connected to the first power distribution layer 122. In the Z-axis direction, the potential moving point pin 43 and the first power distribution layer 122 are stacked and spaced from each other. The potential moving point pin 43 is electrically connected to the auxiliary device 200 (as shown in FIG. 1). It may be understood that the potential moving point pin 43 is spaced from the first substrate 11 and the second substrate 12. In addition, the potential moving point pin 43 and the first substrate 11 are stacked.

Because the potential moving point lead 40 is electrically connected to the first power distribution layer 122, the third power distribution layer 124 is electrically connected to the first power distribution layer 122, and the potential moving point lead 40 is electrically connected to the third power distribution layer 124 via the first power distribution layer 122. In addition, because the first power device 31 is stacked on the side that is of the third power distribution layer 124 and that is away from the second insulation layer 121, and is electrically connected to the third power distribution layer 124, the first power device 31 is electrically connected to the potential moving point lead 40 via the first power distribution layer 122 and the third power distribution layer 124. Because the potential moving point lead 40 is electrically connected to the first power distribution layer 122, and the second power device 32 is stacked on the side that is of the first power distribution layer 122 and that is away from the second insulation layer 121, and is electrically connected to the first power distribution layer 122, the second power device 32 is electrically connected to the potential moving point lead 40 via the first power distribution layer 122.

As shown in FIG. 3, in some embodiments, the connection lead 50 is disposed on the side that is of the first substrate 11 and that faces the second substrate 12. Specifically, in a manner including but not limited to soldering or adhesive bonding, the connection lead 50 is stacked on the side that is of the first power distribution layer 122 and that is away from the second insulation layer 121, and is electrically connected to the first power distribution layer 122. For details, refer to related descriptions of the potential moving point lead 40. Details are not described again. In the X-axis direction, the connection lead 50 is located on the side that is of the second power device 32 and that is away from the second power distribution layer 123, and is spaced from the second power device 32. In the Y-axis direction, the connection lead 50 is located on a side that is of the potential moving point lead 40 and that is away from the plurality of input leads 20, and is spaced from the potential moving point lead 40. The connection lead 50 and the first power distribution layer 122 are stacked, so that a design in which the connection lead 50 is electrically connected to the first power distribution layer 122 is implemented. This design not only has a simple and stable structure, but also has low processing costs, and helps improve structural stability of the power module 100. In addition, a design in which the connection lead 50 and the first power distribution layer 122 are stacked helps increase a connection area between the connection lead 50 and the first power distribution layer 122, helps enhance strength of connection between the connection lead 50 and the first power distribution layer 122, and helps improve structural stability of the power module 100.

For a structure of the connection lead 50, refer to the related descriptions of the potential moving point lead 40. The connection lead 50 includes a third main body portion 51, a third fastening portion 52, and a connection pin 53. In the Z-axis direction, the connection pin 53 and the third fastening portion 52 are fastened to two opposite ends of the third main body portion 51. In the Z-axis direction, the connection pin 53 and the third fastening portion 52 are stacked in a staggered manner and spaced from each other. The third fastening portion 52 is stacked on the side that is of the first power distribution layer 122 and that is away from the second insulation layer 121, and is electrically connected to the first power distribution layer 122. In the Z-axis direction, the connection pin 53 and the first power distribution layer 122 are stacked and spaced from each other. The connection pin 53 is electrically connected to the load device 3000 (as shown in FIG. 1). It may be understood that the connection pin 53 is spaced from the first substrate 11 and the second substrate 12. In addition, the connection pin 53 and the first substrate 11 are stacked. In some other embodiments, the connection pin 53 may alternatively be disposed perpendicular to the first substrate 11, and extend in the direction away from the first substrate 11. The connection pin 53 has various structures, and a design requirement of the connection pin 53 is low. This helps reduce design costs, and helps reduce manufacturing costs of the power module 100. It may be understood that, because both the connection lead 50 and the second power device 32 are electrically connected to the first power distribution layer 122, the connection lead 50 is electrically connected to the second power device 32.

As shown in FIG. 1 and FIG. 3, when the first power device 31 is turned on and the second power device 32 is turned off, the direct current output by the photovoltaic module 1000 may be transmitted to the third power distribution layer 124 through the plurality of input leads 20, and then transmitted to the first power device 31 from the third power distribution layer 124. The first power device 31 may perform voltage conversion on the direct current, and output the maximum-power direct current. The maximum-power direct current is transmitted to the first power distribution layer 122 through a first conductive part 13, then is output to the auxiliary device 200 from the first power distribution layer 122 and the potential moving point lead 40, and then is transmitted to the load device 3000 from the auxiliary device 200, to be supplied to the load device 3000. The auxiliary device 200 is charged and stores the maximum-power direct current.

When the first power device 31 is turned off and the second power device 32 is turned on, the auxiliary device 200 is discharged and outputs the maximum-power direct current, and the maximum-power direct current is transmitted to the second power device 32 from the connection lead 50 through the load device 3000 and the first power distribution layer 122, and then flows back to the auxiliary device 200 from the second power device 32 through the first power distribution layer 122 and the potential moving point lead 40. The maximum-power direct current output by the auxiliary device 200 supplies energy to the load device 3000. It may be understood that because the first power device 31 and the second power device 32 are alternately turned on and turned off, an electrical frequency of the potential moving point lead 40 continuously changes, and the potential moving point lead 40 generates strong electromagnetic interference.

In some embodiments, the fitting lead 60 is disposed on the side that is of the first substrate 11 and that faces the second substrate 12. Specifically, in a manner including but not limited to soldering or adhesive bonding, the fitting lead 60 is stacked on the side that is of the fourth power distribution layer 125 and that is away from the second insulation layer 121, and is electrically connected to the fourth power distribution layer 125. For details, refer to related descriptions of the potential moving point lead 40. Details are not described again. In the X-axis direction, the fitting lead 60 is located on a side that is of the protection device 33 and that is away from the second power distribution layer 123, and is spaced from the protection device 33. In the Y-axis direction, the fitting lead 60 is located on a side that is of the connection lead 50 and that is away from the potential moving point lead 40, and is spaced from the connection lead 50. For example, there are a plurality of fitting leads 60. Specifically, there are five fitting leads 60. In some other embodiments, there may alternatively be two, three, or more other fitting leads 60. In the Y-axis direction, the plurality of fitting leads 60 are sequentially arranged and spaced from each other. The fitting lead 60 and the fourth power distribution layer 125 are stacked, so that a design in which the fitting lead 60 is electrically connected to the fourth power distribution layer 125 is implemented. This design not only has a simple and stable structure, but also has low processing costs, and helps improve structural stability of the power module 100. In addition, a design in which the fitting lead 60 and the fourth power distribution layer 125 are stacked helps increase a connection area between the fitting lead 60 and the fourth power distribution layer 125, helps enhance strength of connection between the fitting lead 60 and the fourth power distribution layer 125, and helps improve structural stability of the power module 100.

For a structure of the fitting lead 60, refer to the related descriptions of the potential moving point lead 40. The fitting lead 60 includes a fourth main body portion 61, a fourth fastening portion 62, and a fitting pin 63. In the Z-axis direction, the fitting pin 63 and the fourth fastening portion 62 are fastened to two opposite ends of the fourth main body portion 61. In the Z-axis direction, the fitting pin 63 and the fourth fastening portion 62 are stacked in a staggered manner and spaced from each other. The fourth fastening portion 62 is stacked on the side that is of the fourth power distribution layer 125 and that is away from the second insulation layer 121, and is electrically connected to the fourth power distribution layer 125. In the Z-axis direction, the fitting pin 63 and the fourth power distribution layer 125 are stacked and spaced from each other. The fitting pin 63 is electrically connected to the load device 3000. It may be understood that the fitting pin 63 is spaced from the first substrate 11 and the second substrate 12. In addition, the fitting pin 63 and the first substrate 11 are stacked. In some other embodiments, the fitting pin 63 may alternatively be disposed perpendicular to the first substrate 11, and extend in the direction away from the first substrate 11. The fitting pin 63 has various structures, and a design requirement of the fitting pin 63 is low. This helps reduce design costs, and helps reduce manufacturing costs of the power module 100.

It may be understood that, because both the fitting lead 60 and the protection device 33 are electrically connected to the fourth power distribution layer 125, the protection device 33 is electrically connected to the fitting lead 60 via the fourth power distribution layer 125. In addition, because the fitting lead 60 is electrically connected to the load device 3000, the protection device 33 is electrically connected to the load device 3000 via the fitting lead 60. Therefore, when both the first power device 31 and the second power device 32 are faulty, the protection device 33 may protect the load device 3000, to avoid damage or burning of the load device 3000, which helps improve use security of the power module 100.

As shown in FIG. 3 and FIG. 4, in some embodiments, the ground lead 70 is disposed on the side that is of the first substrate 11 and that faces the second substrate 12. Specifically, in a manner including but not limited to soldering or adhesive bonding, the ground lead 70 is stacked on a side that is of the second power distribution layer 123 and that is away from the second insulation layer 121, and is electrically connected to the second power distribution layer 123. For example, a seventh connecting piece 7 is disposed between the ground lead 70 and the second power distribution layer 123, and the seventh connecting piece 7 is made of a material including but not limited to tin-lead or a conductive adhesive. The ground lead 70 is stacked, via the seventh connecting piece 7, on the side that is of the second power distribution layer 123 and that is away from the second insulation layer 121, and is electrically connected to the second power distribution layer 123. In the X-axis direction, the ground lead 70 is located on a side that is of the second power distribution layer 123 and that is away from the first power distribution layer 122. It may be understood that in the X-axis direction, the ground lead 70 is disposed away from the input lead 20, the potential moving point lead 40, the connection lead 50, and the fitting lead 60. For example, there are a plurality of ground leads 70. Specifically, there are 10 ground leads 70. In some other embodiments, there may alternatively be one, two, or more other ground leads 70. In the Y-axis direction, the plurality of ground leads 70 are sequentially arranged and spaced from each other. One of the ground leads 70 is grounded, and other ground leads 70 are not grounded. In some other embodiments, alternatively, the plurality of ground leads 70 may be all grounded.

The ground lead 70 and the second power distribution layer 123 are stacked, so that a design in which the ground lead 70 is electrically connected to the second power distribution layer 123 is implemented. This design not only has a simple and stable structure, but also has low processing costs, and helps improve structural stability of the power module 100. In addition, a design in which the ground lead 70 and the second power distribution layer 123 are stacked helps increase a connection area between the ground lead 70 and the second power distribution layer 123, helps enhance strength of connection between the ground lead 70 and the second power distribution layer 123, and helps improve structural stability of the power module 100. It may be understood that the ground lead 70 is disposed on the second substrate 12, to facilitate arrangement of the ground lead 70, and help reduce cabling difficulty.

The ground lead 70 includes a fifth main body portion 71, a fifth fastening portion 72, and a ground pin 73. In the Z-axis direction, the ground pin 73 and the fifth fastening portion 72 are fastened to two opposite ends of the fifth main body portion 71. In the Z-axis direction, the ground pin 73 and the fifth fastening portion 72 are stacked in a staggered manner and spaced from each other. Specifically, the fifth main body portion 71 includes a seventh segment 711, an eighth segment 712, and a ninth segment 713. The seventh segment 711 extends in the X-axis direction, and is disposed opposite to and spaced from the first substrate 11. In the Z-axis direction, the eighth segment 712 and the ninth segment 713 are located on two opposite sides of the seventh segment 711. The eighth segment 712 and the ninth segment 713 are fastened to two opposite ends of the seventh segment 711. In addition, both the eighth segment 712 and the ninth segment 713 are disposed obliquely relative to the seventh segment 711. In the Z-axis direction, the fifth fastening portion 72 is located on a side that is of the eighth segment 712 and that is away from the seventh segment 711, and is fastened to the eighth segment 712. In the Z-axis direction, the ground pin 73 is located on a side that is of the ninth segment 713 and that is away from the seventh segment 711, and is fastened to the ninth segment 713.

The fifth fastening portion 72 is stacked on the side that is of the second power distribution layer 123 and that is away from the second insulation layer 121, and is electrically connected to the second power distribution layer 123. In the Z-axis direction, the ground pin 73 and the second power distribution layer 123 are stacked and spaced from each other. The ground pin 73 is electrically connected to the load device 3000 (as shown in FIG. 1). It may be understood that the ground pin 73 is spaced from the first substrate 11 and the second substrate 12. In addition, the ground pin 73 and the first substrate 11 are stacked.

Because the second power distribution layer 123 is electrically connected to a first conductive layer 112, and the ground lead 70 is stacked on a side that is of the second power distribution layer 123 and that is away from a second insulation layer 121, and is electrically connected to the second power distribution layer 123, the ground lead 70 is electrically connected to the first conductive layer 112 via the second power distribution layer 123, the ground lead 70 and the first conductive layer 112 share potential via the second power distribution layer 123, and the first conductive layer 112 is grounded via the ground lead 70. It may be understood that the ground lead 70 and the first conductive layer 112 share the potential. In addition, because the first conductive layer 112 is located between the first power distribution layer 122 and a second conductive layer 113, the first power distribution layer 122 is electromagnetically shielded from the second conductive layer 113 via the first conductive layer 112. Because the potential moving point lead 40 is stacked on the side that is of the first power distribution layer 122 and that is away from the second insulation layer 121, and is electrically connected to the first power distribution layer 122, and the potential moving point lead 40 and the first power distribution layer 122 share potential, electromagnetic interference generated by the potential moving point lead 40 is shielded by the first conductive layer 112, to implement electromagnetic shielding on the potential moving point lead 40, and further implement electromagnetic shielding on the power module 100. This can avoid deterioration of performance of another device (for example, the auxiliary device 200 and the control module 300) of the photovoltaic optimizer 2000 due to electromagnetic interference on the power module 100, help reduce a distance between the power module 100 and the another device of the photovoltaic optimizer 2000, and facilitate a miniaturization design of the photovoltaic optimizer 2000. It may be understood that the potential moving point lead 40 and the first power distribution layer 122 share the potential, the first power distribution layer 122 is electromagnetically shielded from the second conductive layer 113 via the first conductive layer 112, and the potential moving point lead 40 is electromagnetically shielded from the second conductive layer 113.

It may be understood that, a design in which a projection of the first power distribution layer 122 in a thickness direction of the first substrate 11 (that is, the Z-axis direction) is completely located in a projection of the first conductive layer 112 in the thickness direction of the first substrate 11 helps improve an effect of electromagnetic shielding of the first conductive layer 112 on the first power distribution layer 122, further helps improve an effect of implementing electromagnetic shielding between the second conductive layer 113 and the first power distribution layer 122 via the first conductive layer 112, and helps improve an effect of electromagnetic shielding on the power module 100.

Because a power distribution connection layer 126 is stacked between the first conductive layer 112 and the second insulation layer 121, the power distribution connection layer 126 is located between the first power distribution layer 122 and the second conductive layer 113. In addition, because the power distribution connection layer 126 is electrically connected to the first conductive layer 112, and the power distribution connection layer 126 is grounded via the first conductive layer 112, the power distribution connection layer 126 may implement an electromagnetic shielding function. The first power distribution layer 122 can be electromagnetically shielded from the second conductive layer 113 via both the power distribution connection layer 126 and the first conductive layer 112, which helps improve an electromagnetic shielding effect.

As shown in FIG. 1 and FIG. 3, in some embodiments, the control lead 80 is disposed on the side that is of the first substrate 11 and that faces the second substrate 12. Specifically, in a manner including but not limited to soldering or adhesive bonding, the control lead 80 is stacked on the side that is of the third power distribution layer 124 and that is away from the second insulation layer 121, and is electrically connected to the third power distribution layer 124. For details, refer to related descriptions of the input lead 20. Details are not described again. In the X-axis direction, the control lead 80 is located on a side that is of the first power device 31 and that is away from the second power distribution layer 123, and is spaced from the first power device 31. It may be understood that, in the X-axis direction, the control lead 80 and the ground lead 70 are disposed away from each other. In the Y-axis direction, the control lead 80 is located on a side that is of the plurality of input leads 20 and that is away from the potential moving point leads 40, and is spaced from the plurality of input leads 20. For example, there is one control lead 80. In some other embodiments, there may alternatively be two, three, or more other control leads 80. The control lead 80 and the third power distribution layer 124 are stacked, so that a design in which the control lead 80 is electrically connected to the third power distribution layer 124 is implemented. This design not only has a simple and stable structure, but also has low processing costs, and helps improve structural stability of the power module 100. In addition, a design in which the control lead 80 and the third power distribution layer 124 are stacked helps increase a connection area between the control lead 80 and the third power distribution layer 124, helps enhance strength of connection between the control lead 80 and the third power distribution layer 124, and helps improve structural stability of the power module 100.

For a structure of the control lead 80, refer to the related descriptions of the input lead 20. The control lead 80 includes a sixth main body portion 81, a sixth fastening portion 82, and a control pin 83. In the Z-axis direction, the control pin 83 and the sixth fastening portion 82 are fastened to two opposite ends of the sixth main body portion 81. In the Z-axis direction, the control pin 83 and the sixth fastening portion 82 are stacked in a staggered manner and spaced from each other. The sixth fastening portion 82 is stacked on the side that is of the third power distribution layer 124 and that is away from the second insulation layer 121, and is electrically connected to the third power distribution layer 124. In the Z-axis direction, the control pin 83 and the third power distribution layer 124 are stacked and spaced from each other. The control pin 83 is electrically connected to the control module 300. It may be understood that the control pin 83 is spaced from the first substrate 11 and the second substrate 12. In addition, the control pin 83 and the first substrate 11 are stacked. In some other embodiments, the control pin 83 may alternatively be disposed perpendicular to the first substrate 11, and extend in the direction away from the first substrate 11. The control pin 83 has various structures, and a design requirement of the control pin 83 is low. This helps reduce design costs, and helps reduce manufacturing costs of the power module 100.

Because the first power device 31 is electrically connected to the third power distribution layer 124, and the control lead 80 is electrically connected to the third power distribution layer 124, the control lead 80 is electrically connected to the first power device 31 via the third power distribution layer 124, and the control module 300 may control turn-on and turn-off of the first power device 31 via the control lead 80. Because the second power device 32 is electrically connected to the first power distribution layer 122, the first power distribution layer 122 is electrically connected to the third power distribution layer 124, and the control lead 80 is electrically connected to the third power distribution layer 124, the control lead 80 is electrically connected to the second power device 32 via the first power distribution layer 122 and the third power distribution layer 124, and the control module 300 may control turn-on and turn-off of the second power device 32 via the control lead 80. Therefore, the control module 300 may control the first power device 31 and the second power device 32 to be alternately turned on and turned off, to perform maximum power point tracking on the direct current output by the photovoltaic module 1000.

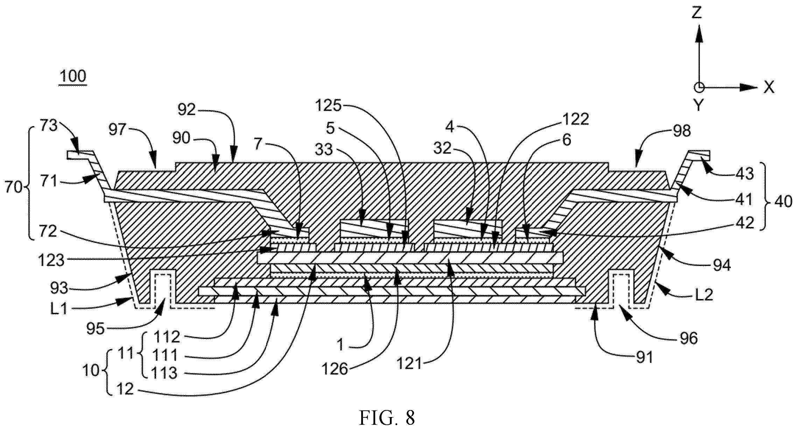

Refer to FIG. 8. With reference to FIG. 2 and FIG. 3, FIG. 8 is a diagram of a structure of the power module 100 shown in FIG. 2, without the heat dissipation substrate 90a, that is cut along an A-Aline.

In some embodiments, the molding part 90 is made of an insulation material including plastic or rubber. The molding part 90 covers the first substrate 11, the second substrate 12, the input lead 20, the first power device 31, the second power device 32, the protection device 33, the potential moving point lead 40, the connection lead 50, the fitting lead 60, the ground lead 70, and the control lead 80. A second conductive layer 113 of the first substrate 11 is exposed outside the molding part 90. Parts of the first main body portion 21 and the input pin 23 of the input lead 20 are exposed outside the molding part 90. Parts of the second main body portion 41 and the potential moving point pin 43 of the potential moving point lead 40 are exposed outside the molding part 90. Parts of the third main body portion 51 and the connection pin 53 of the connection lead 50 are exposed outside the molding part 90. Parts of the fourth main body portion 61 and the fitting pin 63 of the fitting lead 60 are exposed outside the molding part 90. Parts of the fifth main body portion 71 and the ground pin 73 of the ground lead 70 are exposed outside the molding part 90. Parts of the sixth main body portion 81 and the control pin 83 of the control lead 80 are exposed outside the molding part 90.

The molding part 90 covers the first substrate 11, the second substrate 12, the input lead 20, the first power device 31, the second power device 32, the protection device 33, the potential moving point lead 40, the connection lead 50, and the fitting lead 60, the ground lead 70, and the control lead 80, so that the first substrate 11, the second substrate 12, the input lead 20, the first power device 31, the second power device 32, the protection device 33, the potential moving point lead 40, the connection lead 50, the fitting lead 60, the ground lead 70, and the control lead 80 are packaged. A design of the molding part 90 helps improve structural stability of the power module 100.

The molding part 90 includes a first surface 91, a second surface 92, a third surface 93, and a fourth surface 94. In a Z-axis direction, the first surface 91 and the second surface 92 are disposed away from each other. In an X-axis direction, the third surface 93 and the fourth surface 94 are disposed away from each other. The third surface 93 and the fourth surface 94 are fastened between the first surface 91 and the second surface 92. The first surface 91 is flush with a surface that is of a second conductive layer 113 and that is away from a first insulation layer 111. The second conductive layer 113 is exposed to the molding part 90 from the first surface 91. The parts of the first main body portion 21 and the input pin 23 of the input lead 20 are exposed outside the molding part 90 from the fourth surface 94. The parts of the second main body portion 41 and the potential moving point pin 43 of the potential moving point lead 40 are exposed outside the molding part 90 from the fourth surface 94. The parts of the third main body portion 51 and the connection pin 53 of the connection lead 50 are exposed outside the molding part 90 from the fourth surface 94. The parts of the fourth main body portion 61 and the fitting pin 63 of the fitting lead 60 are exposed outside the molding part 90 from the fourth surface 94. The parts of the sixth main body portion 81 and the control pin 83 of the control lead 80 are exposed outside the molding part 90 from the fourth surface 94. The fifth main body portion 71 and the ground pin 73 of the ground lead 70 are exposed outside the molding part 90 from the third surface 93.

In some embodiments, the molding part 90 is provided with a first groove 95. In the Z-axis direction, the first groove 95 is located on a side that is of the ground lead 70 and that faces the second conductive layer 113. A projection of the first groove 95 in a thickness direction of the first substrate 11 (that is, in the Z-axis direction) overlaps a projection of the ground lead 70 in the thickness direction of the first substrate 11 (that is, in the Z-axis direction). For example, the first groove 95 is a rectangular groove. In some other embodiments, the first groove 95 may alternatively be a special-shaped groove including but not limited to a column groove or a spherical groove. The first groove 95 penetrates through the molding part 90 in the Y-axis direction. In addition, the first groove 95 extends in the Z-axis direction and has an opening, and the opening is located on the first surface 91. The projection of the first groove 95 in the Z-axis direction overlaps a projection of the fifth main body portion 71 of the ground lead 70 in the Z-axis direction. In some other embodiments, the first groove 95 may alternatively extend in the X-axis direction and have an opening, and the opening is located on the third surface 93.

The first groove 95 is configured to increase a creepage distance L1 between the second conductive layer 113 and the ground lead 70. A design of the first groove 95 greatly increases the creepage distance L1 between the second conductive layer 113 and the ground lead 70 without increasing a size of the power module 100. This helps reduce a probability of an electric leakage risk in the power module 100, and helps improve use security of the power module 100.

In some embodiments, the molding part 90 is provided with a second groove 96. In the Z-axis direction, the second groove 96 is located on a side that is of the potential moving point lead 40 and that faces the second conductive layer 113. A projection of the second groove 96 in the thickness direction of the first substrate 11 (that is, in the Z-axis direction) overlaps a projection of the potential moving point lead 40 in the thickness direction of the first substrate 11 (that is, in the Z-axis direction). For example, the second groove 96 is a rectangular groove. In some other embodiments, the second groove 96 may alternatively be a special-shaped groove including but not limited to a column groove or a spherical groove. The second groove 96 penetrates through the molding part 90 in the Y-axis direction. In addition, the second groove 96 extends in the Z-axis direction and has an opening, and the opening is located on the first surface 91. The projection of the second groove 96 in the Z-axis direction overlaps a projection of the second main body portion 41 of the potential moving point lead 40 in the Z-axis direction, overlaps a projection of the third main body portion 51 of the connection lead 50 in the Z-axis direction, overlaps a projection of the fourth main body portion 61 of the fitting lead 60 in the Z-axis direction, and overlaps a projection of the sixth main body portion 81 of the control lead 80 in the Z-axis direction. In some other embodiments, the second groove 96 may alternatively extend in the X-axis direction and have an opening, and the opening is located on the fourth surface 94. The second groove 96 and the first groove 95 are symmetrically disposed relative to the second conductive layer 113. This helps improve force uniformity of the molding part 90, helps improve structural stability of the molding part 90, and helps improve structural stability of the power module 100.

The second groove 96 can increase a creepage distance L2 between the second conductive layer 113 and the potential moving point lead 40. In other words, the second groove 96 is configured to increase the creepage distance L2 between the second conductive layer 113 and the potential moving point lead 40. In addition, the second groove 96 can increase a creepage distance between the second conductive layer 113 and the input lead 20, a creepage distance between the second conductive layer 113 and the connection lead 50, and a creepage distance between the second conductive layer 113 and the control lead 80. For details, refer to the creepage distance L2. Details are not described again. In other words, the second groove 96 is configured to increase the creepage distance between the second conductive layer 113 and the input lead 20, the creepage distance between the second conductive layer 113 and the connection lead 50, and the creepage distance between the second conductive layer 113 and the control lead 80. A design of the second groove 96 greatly increases the creepage distance L2 between the second conductive layer 113 and the potential moving point lead 40 without increasing the size of the power module 100, and greatly increases the creepage distance between the second conductive layer 113 and the input lead 20, the creepage distance between the second conductive layer 113 and the connection lead 50, and the creepage distance between the second conductive layer 113 and the control lead 80. This helps reduce a probability of an electric leakage risk in the power module 100, and helps improve use security of the power module 100.

In some embodiments, the molding part 90 is provided with a first fitting groove 97. In the Z-axis direction, the first fitting groove 97 is located on a side that is of the ground lead 70 and that is away from the second conductive layer 113, and a projection of the first fitting groove 97 in the thickness direction of the first substrate 11 (that is, in the Z-axis direction) overlaps the projection of the first groove 95 in the thickness direction of the first substrate 11 (that is, in the Z-axis direction). For example, the first fitting groove 97 is a rectangular groove. In some other embodiments, the first fitting groove 97 may alternatively be a special-shaped groove including but not limited to a column groove or a spherical groove. The first fitting groove 97 penetrates through the molding part 90 in the Y-axis direction. The first fitting groove 97 extends in the Z-axis direction and has an opening, and the opening is located on the second surface 92. In addition, the first fitting groove 97 extends in the X-axis direction and has an opening, and the opening is located on the third surface 93. The projection of the first groove 95 in the Z-axis direction is located in a projection of the first fitting groove 97 in the Z-axis direction. In some other embodiments, the projection of the first fitting groove 97 in the Z-axis direction may alternatively completely overlap the projection of the first groove 95 in the Z-axis direction.

In some embodiments, the molding part 90 is provided with a second fitting groove 98. In the Z-axis direction, the second fitting groove 98 is located on a side that is of the potential moving point lead 40 and that is away from the second conductive layer 113, and a projection of the second fitting groove 98 in the thickness direction of the first substrate 11 (that is, in the Z-axis direction) overlaps the projection of the second groove 96 in the thickness direction of the first substrate 11 (that is, in the Z-axis direction). For example, the second fitting groove 98 is a rectangular groove. In some other embodiments, the second fitting groove 98 may alternatively be a special-shaped groove including but not limited to a column groove or a spherical groove. The second fitting groove 98 penetrates through the molding part 90 in the Y-axis direction. The second fitting groove 98 extends in the Z-axis direction and has an opening, and the opening is located on the second surface 92. In addition, the second fitting groove 98 extends in the X-axis direction and has an opening, and the opening is located on the fourth surface 94. The projection of the second groove 96 in the Z-axis direction is located in the projection of the second fitting groove 98 in the Z-axis direction. In some other embodiments, the projection of the second fitting groove 98 in the Z-axis direction may alternatively completely overlap the projection of the second groove 96 in the Z-axis direction. The second fitting groove 98 and the first fitting groove 97 are symmetrically disposed relative to the second conductive layer 113. This helps improve force uniformity of the molding part 90, helps improve structural stability of the molding part 90, and helps improve structural stability of the power module 100.

Refer to FIG. 3 and FIG. 4 again. In some embodiments, the heat dissipation substrate 90a is disposed on the side that is of the first substrate 11 and that is away from the second substrate 12. Specifically, in a manner including but not limited to soldering or adhesive bonding, the heat dissipation substrate 90a is stacked on a side that is of the second conductive layer 113 and that is away from the first insulation layer 111. In addition, the heat dissipation substrate 90a and the first surface 91 of the molding part 90 are stacked. The heat dissipation substrate 90a is made of a heat conducting material including but not limited to copper and aluminum. The first power device 31, the second power device 32, and the protection device 33 generate a large amount of heat during operation. The heat generated by the first power device 31, the second power device 32, and the protection device 33 during operation may be transferred to the heat dissipation substrate 90a from the second conductive layer 113 through the second substrate 12 and the first substrate 11 in sequence, and then dissipated to an external environment through the heat dissipation substrate 90a, to quickly dissipate heat for the first power device 31, the second power device 32, and the protection device 33. A design of the heat dissipation substrate 90a helps improve efficiency of dissipating heat for the first power device 31, the second power device 32, and the protection device 33, and helps improve efficiency of dissipating heat for the power module 100.

It may be understood that the second substrate 12 and the heat dissipation substrate 90a are disposed on two opposite sides of the first substrate 11. The first power device 31, the second power device 32, and the protection device 33 are all disposed on a side that is of the second substrate 12 and that is away from the first substrate 11. Such a design ensures that the heat generated by the first power device 31, the second power device 32, and the protection device 33 during operation is first transferred to the first substrate 11 through the second substrate 12, and then transferred to the heat dissipation substrate 90a from the first substrate 11. This helps increase a thermal diffusion area for dissipating heat for the first power device 31, the second power device 32, and the protection device 33 through the heat dissipation substrate 90a, greatly reduces overall thermal resistance, and helps improve efficiency of dissipating heat for the first power device 31, the second power device 32, and the protection device 33.

It may be understood that, in the X-axis direction, the first groove 95 and the second groove 96 are located on two opposite sides of the heat dissipation substrate 90a. The first groove 95 is further configured to increase a creepage distance L3 between the heat dissipation substrate 90a and the ground lead 70. The design of the first groove 95 may further greatly increase the creepage distance L3 between the heat dissipation substrate 90a and the ground lead 70 without increasing the size of the power module 100. This helps reduce a probability of an electric leakage risk in the power module 100, and helps improve use security of the power module 100.

The second groove 96 is further configured to increase a creepage distance L4 between the heat dissipation substrate 90a and the potential moving point lead 40, a creepage distance between the heat dissipation substrate 90a and the input lead 20, a creepage distance between the heat dissipation substrate 90a and the connection lead 50, a creepage distance between the heat dissipation substrate 90a and the fitting lead 60, and a creepage distance between the heat dissipation substrate 90a and the control lead 80. The design of the second groove 96 may further greatly increase the creepage distance L4 between the heat dissipation substrate 90a and the potential moving point lead 40, the creepage distance between the heat dissipation substrate 90a and the input lead 20, the creepage distance between the heat dissipation substrate 90a and the connection lead 50, the creepage distance between the heat dissipation substrate 90a and the fitting lead 60, and the creepage distance between the heat dissipation substrate 90a and the control lead 80 without increasing the size of the power module 100. This helps reduce a probability of an electric leakage risk in the power module 100, and helps improve use security of the power module 100.

It may be understood that the second conductive layer 113 and the heat dissipation substrate 90a may be stacked. A design of the first fitting groove 97 can ensure that stress generated when the second conductive layer 113 and the heat dissipation substrate 90a are stacked is not concentrated on a part, provided with the first fitting groove 97, of the molding part 90, to avoid a crack generated on the part, provided with the first fitting groove 97, of the molding part 90. This helps improve reliability of the molding part 90, and helps improve structural stability of the power module 100.

A design of the second fitting groove 98 can ensure that stress generated when the second conductive layer 113 and the heat dissipation substrate 90a are stacked is not concentrated on a part, provided with the second fitting groove 98, of the molding part 90, to avoid a crack generated on the part, provided with the second fitting groove 98, of the molding part 90. This helps improve reliability of the molding part 90, and helps improve structural stability of the power module 100.

Refer to FIG. 1, FIG. 2, and FIG. 3 again. This embodiment of this application provides the power module 100. The power module 100 includes the first substrate 11, the second substrate 12, the first power device 31, the second power device 32, the potential moving point lead 40, and the ground lead 70. The second substrate 12, the first power device 31, the second power device 32, the potential moving point lead 40, and the ground lead 70 are all disposed on a side of the first substrate 11. The first substrate 11 includes the first insulation layer 111, the first conductive layer 112, and the second conductive layer 113. The first conductive layer 112 and the second conductive layer 113 are stacked on two opposite sides of the first insulation layer 111. The second substrate 12 includes the second insulation layer 121 and the first power distribution layer 122. The second insulation layer 121 is disposed on a side that is of the first conductive layer 112 and that is away from the first insulation layer 111, and the first power distribution layer 122 is stacked on a side that is of the second insulation layer 121 and that is away from the first conductive layer 112. Both the first power device 31 and the second power device 32 are electrically connected to the potential moving point lead 40, the first power device 31 and the second power device 32 are alternately turned on and turned off, the potential moving point lead 40 and the first power distribution layer 122 share potential, and the ground lead 70 and the first conductive layer 112 share potential.

The power module 100 provided in this embodiment of this application is configured to: receive a direct current, and perform maximum power point tracking on the direct current, to output a maximum-power direct current. The first power device 31 and the second power device 32 are alternately turned on and turned off, so that the power module 100 can perform maximum power point tracking on the direct current, and output the maximum-power direct current from the potential moving point lead 40. Because the first power device 31 and the second power device 32 are alternately turned on and turned off, an electrical frequency of the potential moving point lead 40 continuously changes, and the potential moving point lead 40 generates strong electromagnetic interference.

The first conductive layer 112 and the second conductive layer 113 are stacked on the two opposite sides of the first insulation layer 111, the second insulation layer 121 is disposed on the side that is of the first conductive layer 112 and that is away from the first insulation layer 111, and the first power distribution layer 122 is stacked on the side that is of the second insulation layer 121 and that is away from the first conductive layer 112, the first conductive layer 112 is located between the first power distribution layer 122 and the second conductive layer 113. In addition, because the ground lead 70 and the first conductive layer 112 share the potential, the first conductive layer 112 is grounded via the ground lead 70, and the first power distribution layer 122 is electromagnetically shielded from the second conductive layer 113 via the first conductive layer 112. Because the potential moving point lead 40 and the first power distribution layer 122 share the potential, the potential moving point lead 40 is electromagnetically shielded from the second conductive layer 113 via the first conductive layer 112, and electromagnetic interference caused by the potential moving point lead 40 is shielded by the first conductive layer 112. In this way, electromagnetic shielding on the potential moving point lead 40 is implemented, and electromagnetic shielding on the power module 100 is further implemented.

Compared with an existing solution in which a shielding frame is disposed outside the power module 100 to implement electromagnetic shielding on the power module 100, in this application, the shielding frame may not be disposed, and mounting space may not be reserved for the shielding frame. This facilitates a miniaturization design of the power module 100. In addition, the power module is easy to manufacture and has a simple structure, low processing costs, a low processing failure risk, and high reliability.

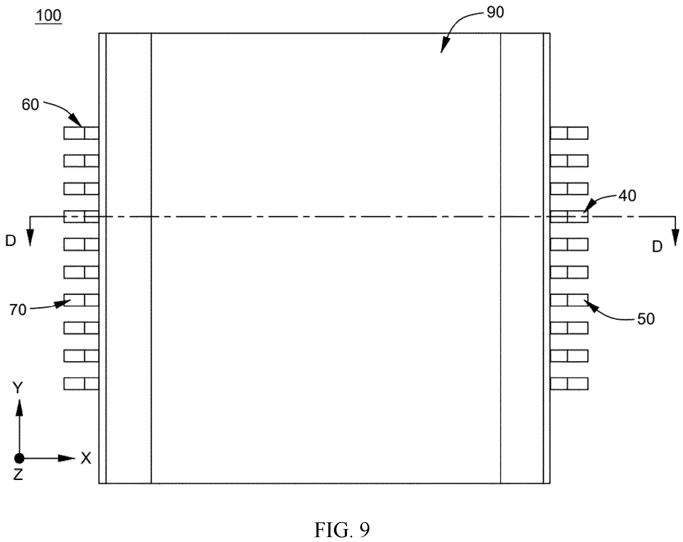

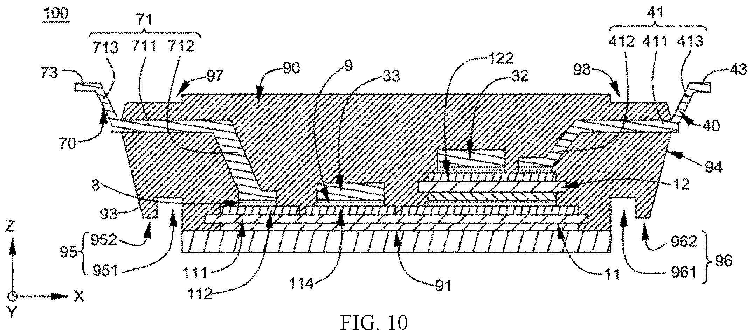

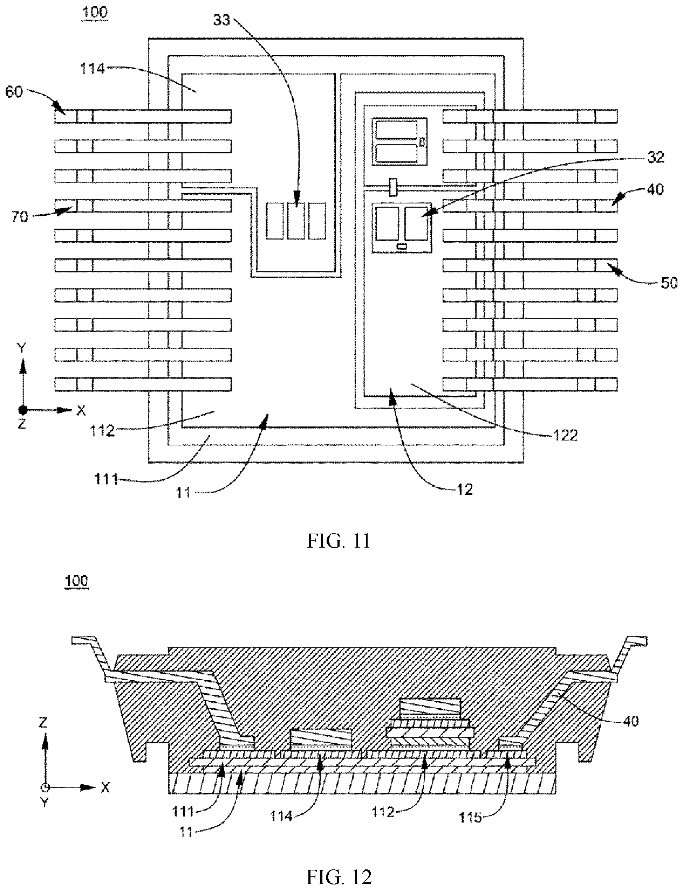

Refer to FIG. 9, FIG. 10, and FIG. 11. With reference to FIG. 1 and FIG. 3, FIG. 9 is a diagram of a structure of the power module 100 shown in FIG. 2 according to another embodiment. FIG. 10 is a diagram of a structure of the power module 100 shown in FIG. 9 that is cut along a D-D line. FIG. 11 is a diagram of a structure of the power module 100 shown in FIG. 10 without a molding part 90 at another angle.

As shown in FIG. 9, FIG. 10, and FIG. 11, in some other embodiments, both the second power distribution layer 123 (as shown in FIG. 3) and the second conductive part 14 (as shown in FIG. 3) are omitted. In a manner including but not limited to soldering or adhesive bonding, the ground lead 70 is stacked on a side that is of the first conductive layer 112 of the first substrate 11 and that is away from the first insulation layer 111, and is electrically connected to the first conductive layer 112. For example, an eighth connecting piece 8 is disposed between the ground lead 70 and the first conductive layer 112. The eighth connecting piece 8 is made of a material including but not limited to tin-lead or a conductive adhesive. The ground lead 70 is stacked, via the eighth connecting piece 8, on the side that is of the first conductive layer 112 and that is away from the first insulation layer 111, and is electrically connected to the first conductive layer 112. There are a plurality of ground leads 70. Specifically, there are seven ground leads 70. In a Y-axis direction, the plurality of ground leads 70 are sequentially arranged and spaced from each other. In addition, in an X-axis direction, the plurality of ground leads 70 are located on a side that is of the second substrate 12 and that is away from the potential moving point lead 40, and are spaced from the second substrate 12. The plurality of ground leads 70 are all disposed away from the potential moving point leads 40.

It may be understood that, because the ground lead 70 is stacked on the side that is of the first conductive layer 112 and that is away from the first insulation layer 111, and is electrically connected to the first conductive layer 112, the first conductive layer 112 may also be grounded via the ground lead 70. In addition, the ground lead 70 and the first conductive layer 112 are stacked, so that the ground lead 70 is electrically connected to the first conductive layer 112, and a design in which the ground lead 70 and the first conductive layer 112 share potential is implemented. This design not only has a simple and stable structure, but also has low processing costs, and helps improve structural stability of the power module 100.

The fourth power distribution layer 125 (as shown in FIG. 3) is omitted. The first substrate 11 further includes a third conductive layer 114, and the third conductive layer 114 is stacked on a side that is of the first insulation layer 111 and that faces the first conductive layer 112. In the X-axis direction, the third conductive layer 114 is located on the side that is of the second substrate 12 and that is away from the potential moving point lead 40, and is spaced from the second substrate 12. In a manner including but not limited to soldering or adhesive bonding, the protection device 33 is stacked on a side that is of the third conductive layer 114 and that is away from the first insulation layer 111, and is electrically connected to the third conductive layer 114. For example, a ninth connecting piece 9 is disposed between the protection device 33 and the third conductive layer 114. The ninth connecting piece 9 is made of a material including but not limited to tin-lead or a conductive adhesive. The protection device 33 is stacked, via the ninth connecting piece 9, on the side that is of the third conductive layer 114 and that is away from the first insulation layer 111, and is electrically connected to the third conductive layer 114. In the X-axis direction, the protection device 33 is located between the second substrate 12 and the ground lead 70, and is spaced from the second substrate 12 and the ground lead 70.

In a manner including but not limited to soldering or adhesive bonding, the fitting lead 60 is stacked on the side that is of the third conductive layer 114 and that is away from the first insulation layer 111, and is electrically connected to the third conductive layer 114. For details, refer to related descriptions of the protection device 33. Details are not described again. In the X-axis direction, the fitting lead 60 is located on a side that is of the protection device 33 and that is away from the second substrate 12, and is spaced from the protection device 33. In the Y-axis direction, the fitting lead 60 is located on a side of the plurality of ground leads 70, and is spaced from the plurality of ground leads 70. There are a plurality of fitting leads 60. Specifically, there are three fitting leads 60. The plurality of fitting leads 60 are sequentially arranged in the Y-axis direction and spaced from each other.

It may be understood that both the protection device 33 and the fitting lead 60 are stacked on the side that is of the third conductive layer 114 and that is away from the first insulation layer 111, and are electrically connected to the third conductive layer 114. The protection device 33 and the fitting lead 60 may be disposed on the first substrate 11, or may be disposed on the second substrate 12. An arrangement requirement of the protection device 33 and the fitting lead 60 is low, which helps reduce arrangement costs of the protection device 33 and the fitting lead 60, and helps reduce manufacturing costs of the power module 100. There are a plurality of connection leads 50. Specifically, there are six connection leads 50. The plurality of connection leads 50 help improve efficiency of power transmission between the load device 3000 (as shown in FIG. 1) and the first power distribution layer 122, further help improve efficiency of power transmission between the load device 3000 and the second power device 32, and help improve performance of the power module 100.

The first groove 95 may alternatively be a special-shaped groove. Specifically, the first groove 95 includes a first slot 951 and a second slot 952. Both the first slot 951 and the second slot 952 are rectangular slots. The first slot 951 penetrates through the molding part 90 in the Y-axis direction. The first slot 951 extends in a Z-axis direction and has an opening, and the opening is located on the first surface 91. In the X-axis direction, the second slot 952 is located on a side that is of the first slot 951 and that is away from the first substrate 11, and communicates with the first slot 951. The second slot 952 penetrates through the molding part 90 in the Y-axis direction. The second slot 952 extends in the Z-axis direction and has an opening, and the opening is located on the first surface 91. In addition, the second slot 952 extends in the X-axis direction and has an opening, and the opening is located on the third surface 93. A depth of the first slot 951 is greater than a depth of the second slot 952 in the Z-axis direction. It may be understood that the first groove 95 may have various shapes. This helps reduce design costs of the first groove 95, and helps reduce manufacturing costs of the power module 100.

The second groove 96 may alternatively be a special-shaped groove. Specifically, the second groove 96 includes a third slot 961 and a fourth slot 962. Both the third slot 961 and the fourth slot 962 are rectangular slots. The third slot 961 penetrates through the molding part 90 in the Y-axis direction. The third slot 961 extends in the Z-axis direction and has an opening, and the opening is located on the first surface 91. In the X-axis direction, the fourth slot 962 is located on a side that is of the third slot 961 and that is away from the first substrate 11, and communicates with the third slot 961. The fourth slot 962 penetrates through the molding part 90 in the Y-axis direction. The fourth slot 962 extends in the Z-axis direction and has an opening, and the opening is located on the first surface 91. In addition, the fourth slot 962 extends in the X-axis direction and has an opening, and the opening is located on the fourth surface 94. A depth of the third slot 961 is greater than a depth of the fourth slot 962 in the Z-axis direction. It may be understood that the second groove 96 may have various shapes. This helps reduce design costs of the second groove 96, and helps reduce manufacturing costs of the power module 100.

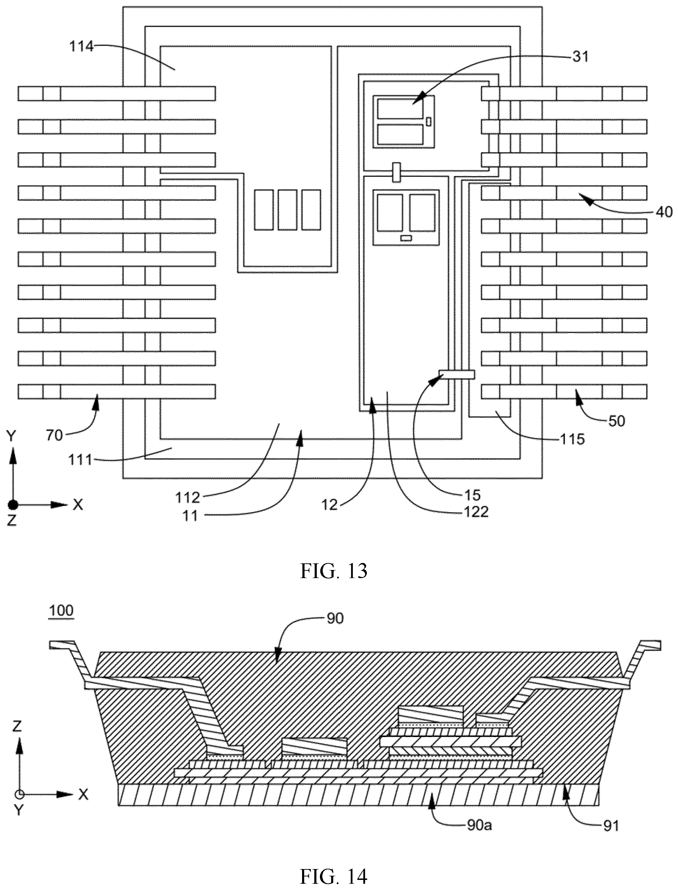

Refer to FIG. 12 and FIG. 13. FIG. 12 is a diagram of a structure of the power module 100 shown in FIG. 9 that is cut along a D-D line according to another embodiment. FIG. 13 is a diagram of a structure of the power module 100 shown in FIG. 12 without a molding part 90 at another angle.

In some other embodiments, the first substrate 11 further includes a connection conductive layer 115, and the connection conductive layer 115 is stacked on the side that is of the first insulation layer 111 and that faces the first conductive layer 112. The connection conductive layer 115 is electrically connected to the first power distribution layer 122. The potential moving point lead 40 is stacked on a side that is of the connection conductive layer 115 and that is away from the first insulation layer 111, and is electrically connected to the connection conductive layer 115. The connection lead 50 is stacked on the side that is of the connection conductive layer 115 and that is away from the first insulation layer 111, and is electrically connected to the connection conductive layer 115.

Specifically, in the X-axis direction, the connection conductive layer 115 is located on a side that is of the first conductive layer 112 and that is away from the third conductive layer 114, and is spaced from the first conductive layer 112. The connection conductive layer 115 is located on a side that is of the second substrate 12 and that is away from the ground lead 70, and is spaced from the second substrate 12. A third conductive part 15 is disposed between the connection conductive layer 115 and the first power distribution layer 122. For example, the third conductive part 15 may be a conductive device including but not limited to a cable or a metal part. In a manner including but not limited to soldering or adhesive bonding, one end of the third conductive part 15 is stacked on a side that is of the first power distribution layer 122 and that is away from the second insulation layer 121, and is electrically connected to the first power distribution layer 122; and the other end of the third conductive part 15 is stacked on the side that is of the connection conductive layer 115 and that is away from the first insulation layer 111, and is electrically connected to the connection conductive layer 115. The first power distribution layer 122 is electrically connected to the connection conductive layer 115 via the third conductive part 15.

The potential moving point lead 40 is stacked on the side that is of the connection conductive layer 115 and that is away from the first insulation layer 111, is electrically connected to the connection conductive layer 115, and is located on a side that is of the connection conductive layer 115 and that is away from the second substrate 12. Because the connection conductive layer 115 is electrically connected to the first power distribution layer 122, and the potential moving point lead 40 is stacked on the side that is of the connection conductive layer 115 and that is away from the first insulation layer 111, and is electrically connected to the connection conductive layer 115, the potential moving point lead 40 is also electrically connected to the first power distribution layer 122 via the connection conductive layer 115. In this way, the potential moving point lead 40 may be disposed on the first substrate 11, and the potential moving point lead 40 is arranged in various manners.

The connection lead 50 is stacked on the side that is of the connection conductive layer 115 and that is away from the first insulation layer 111, is electrically connected to the connection conductive layer 115, and is located on the side that is of the connection conductive layer 115 and that is away from the second substrate 12. In the Y-axis direction, the connection lead 50 is located on a side that is of the potential moving point lead 40 and that is away from the first power device 31, and is spaced from the potential moving point lead 40. Because the connection conductive layer 115 is electrically connected to the first power distribution layer 122, and the connection lead 50 is stacked on the side that is of the connection conductive layer 115 and that is away from the first insulation layer 111, and is electrically connected to the connection conductive layer 115, the connection lead 50 is also electrically connected to the first power distribution layer 122 via the connection conductive layer 115. In this way, the connection lead 50 may be disposed on the first substrate 11, and the connection lead 50 is arranged in various manners.

Refer to FIG. 14. With reference to FIG. 10, FIG. 14 is a diagram of a structure of the power module 100 shown in FIG. 9 that is cut along a D-D line according to another embodiment.

In some other embodiments, the first groove 95, the second groove 96, the first fitting groove 97, and the second fitting groove 98 of the molding part 90 may all be omitted. This helps increases a connection area between the heat dissipation substrate 90a and the first surface 91 of the molding part 90, helps enhance strength of connection between the heat dissipation substrate 90a and the molding part, and helps improve structural stability of the power module 100.

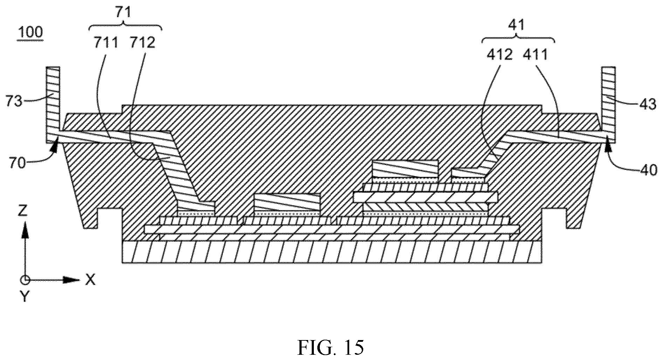

Refer to FIG. 15. With reference to FIG. 10, FIG. 15 is a diagram of a structure of the power module 100 shown in FIG. 9 that is cut along a D-D line according to another embodiment.

In some other embodiments, the potential moving point pin 43 may alternatively be disposed perpendicular to the first substrate 11, and extend in the direction away from the first substrate 11. Specifically, the second main body portion 41 of the potential moving point lead 40 includes the fourth segment 411 and the fifth segment 412. The sixth segment 413 of the second main body portion 41 is omitted. The potential moving point pin 43 is located on a side that is of the fourth segment 411 and that is away from the fifth segment 412, and is fastened to the fourth segment 411. In addition, the potential moving point pin 43 is disposed perpendicular to the fourth segment 411. The potential moving point pin 43 extends in a direction away from the fifth segment 412. Because the fourth segment 411 extends in the X-axis direction, and is disposed opposite to and spaced from the first substrate 11, and the potential moving point pin 43 is disposed perpendicular to the fourth segment 411, and extends in the direction away from the fifth segment 412, the potential moving point pin 43 is disposed perpendicular to the first substrate 11, and extends in the direction away from the first substrate 11. It may be understood that the potential moving point pin 43 has various structures, and a design requirement of the potential moving point pin 43 is low. This helps reduce design costs, and helps reduce manufacturing costs of the power module 100.

The ground pin 73 may alternatively be disposed perpendicular to the first substrate 11, and extend in the direction away from the first substrate 11. Specifically, the fifth main body portion 71 of the ground lead 70 includes the seventh segment 711 and the eighth segment 712. The ninth segment 713 of the fifth main body portion 71 is omitted. The ground pin 73 is located on a side that is of the seventh segment 711 and that is away from the eighth segment 712, and is fastened to the seventh segment 711. In addition, the ground pin 73 is disposed perpendicular to the seventh segment 711. The ground pin 73 extends in a direction away from the eighth segment 712. Because the seventh segment 711 extends in the X-axis direction, and is disposed opposite to and spaced from the first substrate 11, and the ground pin 73 is disposed perpendicular to the seventh segment 711, and extends in the direction away from the eighth segment 712, the ground pin 73 is disposed perpendicular to the first substrate 11, and extends in the direction away from the first substrate 11. It may be understood that the ground pin 73 has various structures, and a design requirement of the ground pin 73 is low. This helps reduce design costs, and helps reduce manufacturing costs of the power module 100.

## Claims

1. A power module, wherein the power module comprises a first substrate, a second substrate, a first power device, a second power device, a potential moving point lead, and a ground lead, wherein the second substrate, the first power device, the second power device, the potential moving point lead, and the ground lead are all disposed on a side of the first substrate;
the first substrate comprises a first insulation layer, a first conductive layer, and a second conductive layer, and the first conductive layer and the second conductive layer are stacked on two opposite sides of the first insulation layer;
the second substrate comprises a second insulation layer and a first power distribution layer, the second insulation layer is disposed on a side that is of the first conductive layer and that is away from the first insulation layer, and the first power distribution layer is stacked on a side that is of the second insulation layer and that is away from the first conductive layer; and
both the first power device and the second power device are electrically connected to the potential moving point lead, the first power device and the second power device are alternately turned on and turned off, the potential moving point lead and the first power distribution layer share potential, and the ground lead and the first conductive layer share potential.

2. The power module according to claim 1, wherein a projection of the first power distribution layer in a thickness direction of the first substrate is completely located in a projection of the first conductive layer in the thickness direction of the first substrate.

3. The power module according to claim 1, wherein the second substrate comprises a power distribution connection layer, and the power distribution connection layer is stacked between the first conductive layer and the second insulation layer, and is electrically connected to the first conductive layer.

4. The power module according to any one of claims 1 to 3, wherein the potential moving point lead is stacked on a side that is of the first power distribution layer and that is away from the second insulation layer, and is electrically connected to the first power distribution layer; or
the first substrate comprises a connection conductive layer, the connection conductive layer is stacked on a side that is of the first insulation layer and that faces the first conductive layer, the connection conductive layer is electrically connected to the first power distribution layer, and the potential moving point lead is stacked on a side that is of the connection conductive layer and that is away from the first insulation layer, and is electrically connected to the connection conductive layer.

5. The power module according to claim 4, wherein the second substrate comprises a second power distribution layer, the second power distribution layer is stacked on a side that is of the second insulation layer and that faces the first power distribution layer, and is electrically connected to the first conductive layer, and the ground lead is stacked on a side that is of the second power distribution layer and that is away from the second insulation layer, and is electrically connected to the second power distribution layer; or
the ground lead is stacked on the side that is of the first conductive layer and that is away from the first insulation layer, and is electrically connected to the first conductive layer.

6. The power module according to claim 4, wherein the second substrate comprises a third power distribution layer, the third power distribution layer is stacked on a side that is of the second insulation layer and that faces the first power distribution layer, and is electrically connected to the first power distribution layer, the first power device is stacked on a side that is of the third power distribution layer and that is away from the second insulation layer, and is electrically connected to the third power distribution layer, and the second power device is stacked on the side that is of the first power distribution layer and that is away from the second insulation layer, and is electrically connected to the first power distribution layer.

7. The power module according to any one of claims 1 to 3, wherein the power module comprises a protection device and a fitting lead, the second substrate comprises a fourth power distribution layer, the fourth power distribution layer is stacked on a side that is of the second insulation layer and that faces the first power distribution layer, and both the protection device and the fitting lead are stacked on a side that is of the fourth power distribution layer and that is away from the second insulation layer, and are electrically connected to the fourth power distribution layer; or
the first substrate comprises a third conductive layer, the third conductive layer is stacked on a side that is of the first insulation layer and that faces the first conductive layer, and both the protection device and the fitting lead are stacked on a side that is of the third conductive layer and that is away from the first insulation layer, and are electrically connected to the third conductive layer.

8. The power module according to any one of claims 1 to 3, wherein the ground lead comprises a ground pin, the potential moving point lead comprises a potential moving point pin, and both the ground pin and the potential moving point pin are spaced from the first substrate and the second substrate; and
the power module comprises a molding part, the molding part covers the first substrate, the second substrate, the first power device, the second power device, the ground lead, and the potential moving point lead, and the second conductive layer, the ground pin, and the potential moving point pin are all exposed outside the molding part.

9. The power module according to claim 8, wherein the molding part is provided with a first groove, the first groove is located on a side that is of the ground lead and that faces the second conductive layer, a projection of the first groove in the thickness direction of the first substrate overlaps a projection of the ground lead in the thickness direction of the first substrate, and the first groove is configured to increase a creepage distance between the second conductive layer and the ground lead.

10. The power module according to claim 9, wherein the molding part is provided with a first fitting groove, the first fitting groove is located on a side that is of the ground lead and that is away from the second conductive layer, and a projection of the first fitting groove in the thickness direction of the first substrate overlaps the projection of the first groove in the thickness direction of the first substrate.

11. The power module according to claim 8, wherein the molding part is provided with a second groove, the second groove is located on a side that is of the potential moving point lead and that faces the second conductive layer, a projection of the second groove in the thickness direction of the first substrate overlaps a projection of the potential moving point lead in the thickness direction of the first substrate, and the second groove is configured to increase a creepage distance between the second conductive layer and the potential moving point lead.

12. The power module according to claim 11, wherein the molding part is provided with a second fitting groove, the second fitting groove is located on a side that is of the potential moving point lead and that is away from the second conductive layer, and a projection of the second fitting groove in the thickness direction of the first substrate overlaps the projection of the second groove in the thickness direction of the first substrate.

13. The power module according to claim 8, wherein the ground pin and the first substrate are stacked; or
the ground pin is disposed perpendicular to the first substrate, and extends in a direction away from the first substrate.

14. The power module according to claim 8, wherein the potential moving point pin and the first substrate are stacked; or
the potential moving point pin is disposed perpendicular to the first substrate, and extends in a direction away from the first substrate.

15. A photovoltaic optimizer, wherein the photovoltaic optimizer comprises a control module and the power module according to any one of claims 1 to 14, and the control module is configured to control the first power device and the second power device to be alternately turned on and turned off.
